# EUROPEAN PATENT APPLICATION

(11) **EP 2 869 122 A1**
(43) Date of publication of application: **06.05.2015**
(21) Application number: 13808606.1
(22) Date of filing: 18.06.2013
(51) Int. Cl.: G03F 7/32, C02F 1/04, G03F 7/00, G03F 7/004, G03F 7/11

(54) **METHOD FOR CONCENTRATING PROCESSING WASTE LIQUID AND METHOD FOR RECYCLING PROCESSING WASTE LIQUID**

(30) Priority: 29.06.2012 JP 2012147791
(71) Applicant: Fujifilm Corporation, Minato-ku Tokyo 106-8620 (JP)
(72) Inventor: WARIISHI, Koji, Haibara-gun Shizuoka 421-0396 (JP); KOBAYASHI, Fumikazu, Haibara-gun Shizuoka 421-0396 (JP); MORI, Takanori, Haibara-gun Shizuoka 421-0396 (JP)
(74) Representative: Hoffmann Eitle
(86) International application number: PCT/JP2013/066758
(87) International publication number: WO 2014/002835

(57) **Abstract**

The invention provides a method of concentrating a waste liquid produced by development, the method including: obtaining a waste liquid produced by: exposing a planographic printing plate precursor, including: an image recording layer including: an infrared absorbing dye, a polymerization initiator, and a polymerizable compound, and a protective layer on a support, and performing a development process by using a developer liquid that contains an anionic surfactant having a naphthalene skeleton and/or a nonionic surfactant having a naphthalene skeleton in an amount of 1-10% by mass, that contains an organic solvent that has a boiling temperature in a range of 100-300°C in an amount of 2% by mass or less, and that has a pH of 6.0-9.5; and evaporation-concentrating the waste liquid such that [an amount of the waste liquid after the concentration/an amount of the waste liquid before the concentration] is from 1/10 to 1/2 on a volume basis.

## Description

### Technical Field

The present invention relates to a method of concentrating a waste liquid produced by subjecting a photosensitive planographic printing plate precursor to a development process using an automatic developing machine, and a method of recycling the waste liquid.

### Background Art

Conventionally, in the case of subjecting a photosensitive planographic printing plate precursor to a development process using an automatic developing machine, a method in which a development replenisher liquid is supplied to a developer liquid in each of the steps is employed in order to maintain the concentrations of the components that are lost by the processing or the passage of time or pH, in order to maintain the performance of the developer liquid. In the case in which the performance of the developer liquid goes outside the tolerable range even when carrying out such a replenishment, the entire developer liquid is disposed of.

An ordinary waste liquid produced by plate-making is strongly alkaline. A so-called non-processing type planographic printing plate precursor, in which a non-image area after exposure can be removed while not carrying out a specific alkali developing processing, has attracted attention as a planographic printing plate precursor. The non-processing type planographic printing plate precursor does not require being subjected to a development process in an alkali development bath, and is set in a printer after exposure to perform printing, thereby making an unexposed area be developed by an ink or a dampening solution at an early stage in a printing process. Even such a non-processing type planographic printing plate precursor, d is subjected to a development process in which development is performed by a neutral to relatively low alkaline developer liquid, is carried out for the purpose of reducing an amount of printing paper use and increasing the processing efficiency. In the development process of the non-processing type planographic printing plate precursor, a development processing liquid containing a surfactant is used, but this waste liquid cannot be discharged as an ordinary discharge liquid, and accordingly, a certain waste liquid processing is required.

However, a huge space is required for storage of the waste liquid until the waste liquid processing. In addition, waste liquid processing facilities have problems such as necessity for a significantly large place.

In order to address these problems, for example, a method of concentrating the waste liquid by blowing warm air to a waste liquid storage tank is proposed in Japanese Patent Application Laid-Open (JP-A) No. H05-341535, and a technology of aggregating aggregative components by neutralizing the waste liquid produced by a process and adding an aggregating agent is proposed in JP-A No. H02-157084.

Furthermore, an apparatus for reducing waste liquid produced by a planographic printing plate-making process has been proposed, the apparatus being capable of decreasing the discharge amount of the plate-making process waste liquid and capable of easily reutilizing water generated in the course of the processing of the plate-making process waste liquid (see, for example, Japanese Patent No. 4774124).

### SUMMARY OF INVENTION

### Problem to be Solved

In the technology of concentrating the waste liquid by blowing warm air, the evaporation amount is not large, and, therefore, it takes a long time to concentrate the plate-making process waste liquid. Accordingly, the effect in terms of reducing the amount of waste liquid is not sufficient. Further, the processing of evaporated moisture has not been considered.

The technology of using an aggregating agent has a problem in that costs are incurred for processing the waste liquid due to the necessity of an aggregating agent. Furthermore, in the case of plate-making process waste liquid that includes polymers, there has been a problem in that drop-like solids remaining inside an evaporation pot adhere to the wall surfaces of the evaporation pot and makes the wall surfaces dirty, and in that the pipes in the waste liquid processing apparatus is likely to be clogged.

For a plate-making processing of a planographic printing plate precursor having a negative type or positive type photosensitive image recording layer requiring an ordinary alkali development, various investigations as described above have been conducted. However, for the problems of waste liquids in a plate-making processing with a non-processing type planographic printing plate precursor, sufficient investigations have still not be conducted.

According to the invention, that has been made in consideration of the problems above, it is possible to provide a method of concentrating a waste liquid produced by development which enables obtaining a planographic printing plate having an excellent dirt resistance and inking property with suppressing generation of development scum in a development processing bath while not decreasing the developing speed in a development step in an automatic developing machine. Further, foaming at a time of concentrating the waste liquid is suppressed in a developing waste liquid concentrating step and concentration is efficiently carried out, and precipitation of solids is suppressed so that washing of a concentration pot or the like can be easily carried out.

In addition, according to the invention, it is also possible to provide a method of recycling a waste liquid produced by a development, in which regenerated water obtained at a time of concentrating the waste liquid as a developer liquid, washing water, oil-desensitizing processing liquid, or the like is reutilized, whereby dirt due to the accumulation of deposits in a development bath or oil-desensitizing processing bath of an automatic developing machine is small, and generation of precipitated matter is suppressed even in the case of a continuous plate-making processing over a long period of time.

### Solution to Problem

As a result of extensive studies, it has been found that the above-described problems can be solved by using a developer liquid containing a specific surfactant at a time of carrying out development, thereby completing the invention. That is, the configuration of the invention is as follows.
[1] A method of concentrating a waste liquid produced by developing a photosensitive planographic printing plate, the method comprising:
   obtaining a waste liquid that is produced by:
      exposing a photosensitive planographic printing plate precursor, comprising: (i) a radical-polymerizable image recording layer comprising: (a) an infrared absorbing dye, (b) a polymerization initiator, and (c) a polymerizable compound, and (ii) a protective layer, in this order on a support, and
      subjecting, in a development processing bath of an automatic developing machine for development, the exposed photosensitive planographic printing plate precursor to a development process by using a developer liquid that contains at least one surfactant selected from the group consisting of an anionic surfactant having a naphthalene skeleton and a nonionic surfactant having a naphthalene skeleton in an amount of 1% by mass to 10% by mass, that contains an organic solvent that has a boiling temperature in a range of from 100°C to 300°C in an amount of equal to or less than 2% by mass, and that has a pH of 6.0 to 9.5; and
   evaporation-concentrating, in an evaporation-concentration apparatus, the waste liquid such that a ratio of an amount of the waste liquid after the concentration to an amount of the waste liquid before the concentration is from 1/10 to 1/2 on a volume basis.
[2] The method according to [1], further comprising producing regenerated water by condensing, via cooling, water vapor generated during the evaporation-concentrating.
[3] The method according to [1] or [2], wherein the surfactant is a compound comprising a polyoxyalkylene chain that comprises at least one selected from the group consisting of an oxyethylene group and an oxypropylene group.
[4] The method according to [3], wherein a total number of the oxyethylene group and the oxypropylene group contained in the polyoxyalkylene chain, as a repeating unit, is from 5 to 30.
[5] The method according to any one of [1] to [4], wherein the protective layer comprises a hydrophilic polymer comprising a repeating unit represented by the following Formula (1) and a repeating unit represented by the following Formula (2): 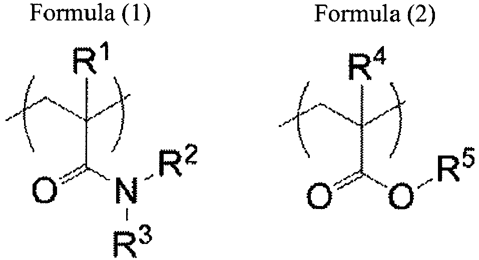 wherein, in Formulae (1) and (2), each of R¹ and R⁴ independently represents a hydrogen atom or a methyl group; each of R² and R³ independently represents a hydrogen atom, a methyl group, or an ethyl group; R⁵ represents a linear, branched, or cyclic unsubstituted alkyl group having 2 to 8 carbon atoms, a substituted alkyl group that may have an aromatic ring or a heterocycle as a substituent, or a substituent represented by the following Formula (3); 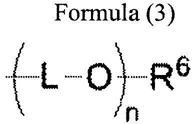 wherein, in Formula (3), L represents an alkylene group having 2 to 6 carbon atoms; R⁶ represents a linear, branched, or cyclic unsubstituted alkyl group having 4 to 8 carbon atoms or an aromatic substituted alkyl group; and n represents an average addition molar number of the polyether and is in a range of from 2 to 4.
[6] The method according to [5], wherein the hydrophilic polymer further comprises a repeating unit represented by the following Formula (4): 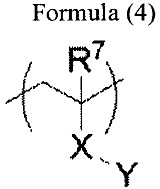 wherein, in Formula (4), R⁷ represents a hydrogen atom or a methyl group; X represents a single bond, a divalent linking group selected from structures represented by the following Structural Group (5), or a divalent linking group formed by a combination of a plurality of structures selected from structures represented by the following Structural Group (6); and Y represents a carboxylic acid group, a carboxylate salt group, a sulfonic acid group, a sulfonate salt group, a phosphoric acid group, a phosphate salt group, a phosphonic acid group, a phosphonate salt group, a hydroxyl group, a carboxybetaine group, a sulfobetaine group, an ammonium group, or a polyether group represented by the following Formula (7): 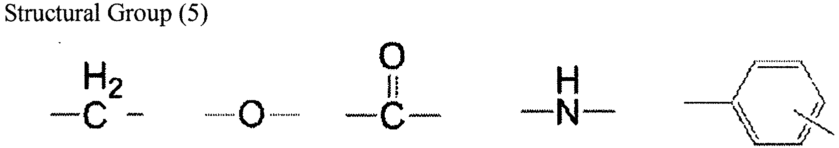 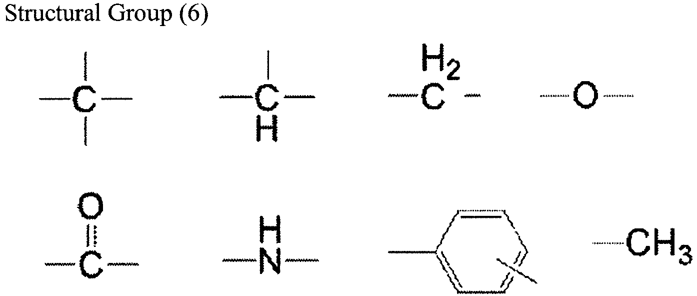 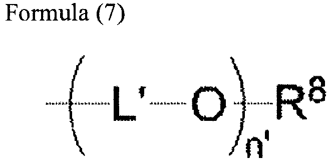 wherein, in Formula (7), L' represents an alkylene group having 2 or 3 carbon atoms; R⁸ represents a hydrogen atom or a methyl group; and n' represents an average addition molar number of the polyether and is in a range of from 2 to 4.
[7] A method of recycling a waste liquid produced by development of a photosensitive planographic printing plate, the method comprising:
   exposing a photosensitive planographic printing plate precursor, comprising: (i) a radical-polymerizable image recording layer comprising: (a) an infrared absorbing dye, (b) a polymerization initiator, and (c) a polymerizable compound, and (ii) a protective layer, in this order on a support; and
   subjecting, in a development processing bath of an automatic developing machine for development, the exposed photosensitive planographic printing plate precursor to a development process by using a developer liquid that contains at least one surfactant selected from the group consisting of an anionic surfactant having a naphthalene skeleton and a nonionic surfactant having a naphthalene skeleton in an amount of 1 % by mass to 10% by mass, that contains an organic solvent that has a boiling temperature in a range of from 100°C to 300°C in an amount of equal to or less than 2% by mass, and that has a pH of 7.0 to 9.5;
   evaporation-concentrating, in an evaporation-concentration apparatus, a waste liquid that is produced by the development process, such that a ratio of an amount of the waste liquid after the concentration to an amount of the waste liquid before the concentration is from 1/10 to 1/2 on a volume basis;
   producing regenerated water by condensing, via cooling, water vapor generated during the evaporation-concentrating; and
   supplying the regenerated water to the automatic developing machine.
[8] The method according to [7], further comprising, after the development process, subjecting the photosensitive planographic printing plate precursor to plate-making by washing with water and oil-desensitizing of a non-image area with an oil-desensitizing liquid.

### [Effects of Invention]

According to the invention, it is possible to provide a method of concentrating a waste liquid produced by development which enables obtaining a planographic printing plate having an excellent dirt resistance and inking property with suppressing generation of development scum in a development processing bath while not decreasing the developing speed in a development step in an automatic developing machine. Further, foaming at a time of concentrating the waste liquid is suppressed in a developing waste liquid concentrating step and concentration is efficiently carried out, and precipitation of solids is suppressed so that washing of a concentration pot or the like can be easily carried out.

In addition, according to the invention, it is also possible to provide a method of recycling a waste liquid produced by a development, in which regenerated water obtained at a time of concentrating the waste liquid as a developer liquid, washing water, oil-desensitizing processing liquid, or the like is reutilized, whereby dirt due to the accumulation of deposits in a development bath or oil-desensitizing processing bath of an automatic developing machine is small, and generation of precipitated matter is suppressed even in the case of a continuous plate-making processing over a long period of time

### BRIEF DESCRIPTION OF DRAWINGS

Fig. 1 is a conceptual diagram illustrating the flow in an apparatus relating to a method of recycling a waste liquid produced by a development according to the invention.
Fig. 2 is a schematic diagram illustrating an example of the configuration of a machine for automatic developing of a photosensitive planographic printing plate precursor according to the invention.

### DESCRIPTION OF EMBODIMENTS

In the present specification, when the amounts of the respective components in a composition are indicated, in the case where plural materials corresponding to a component are present in the composition, an amount of the component means a total amount of plural materials present in the composition unless otherwise specifically limited.

A numerical value range as noted in the specification represents a range which includes a numerical value shown as a lower limit in the numerical value range as a minimum value, and further include a numerical value shown as an upper limit of the numerical value range as a maximum value. In notations of groups (atomic groups) in the specification, a notation of a group (atomic group) which does not specify the presence or absence of substitution intends to include both of a group having a substituent and a group having no substituent in a scope of the group. For example, "an alkyl group" is intended to include not only an alkyl group having no substituent (an unsubstituted alkyl group) but also an alkyl group having a substituent (a substituted alkyl group).

In the specification, "(meth)acrylic acid" may indicate either or both of acrylic acid and methacrylic acid in some cases, and "(meth)acrylate" may indicate to represent either or both of acrylate and methacrylate in some cases.

A content of a component is expressed in terms of mass unless otherwise specifically limited, "% by mass" represents a ratio with respect to a total amount of a composition. A "solid" represents a component(s) other than a solvent in a composition unless otherwise specifically limited.

Not only a step which is independent, but also a step which is unable to be clearly distinguished from other steps is included in the term "step", as long as it is a step which accomplishes the action desired therein.certain

A weight average molecular weight in the specification is a value measured by Gel Permeation Chromatography (GPC). The GPC was performed using an HLC-8020GPC (manufactured by TOSOH Corporation), using TSKGEL SUPERHZM-H, TSKGEL SUPERHZ4000, and TSKGEL SUPERHZ200 (manufactured by TOSOH Corporation, 4.6 mm ID × 15 cm) as columns, and tetrahydrofuran (THF) as an eluent, and by setting the temperature of a column oven to 40°C. For the calculation of the molecular weight, polystyrene standards were used.

### [Method of concentrating Waste Liquid Produced by Development of Photosensitive Planographic Printing Plate]

A method of concentrating a waste liquid produced by developing a photosensitive planographic printing plate, that is one embodiment of the invention (hereinafter referred to as a method of concentrating a waste liquid in some cases), includes obtaining a waste liquid that is produced by exposing a photosensitive planographic printing plate precursor having a radical-polymerizable image recording layer containing (a) an infrared absorbing dye, (b) a polymerization initiator, and (c) a polymerizable compound, and a protective layer in this order on a support, and then subjecting, in a development processing bath of an automatic developing machine for development, the exposed photosensitive planographic printing plate precursor to a development process by using a developer liquid that contains at least one surfactant selected from the group consisting of an anionic surfactant having a naphthalene skeleton and a nonionic surfactant having a naphthalene skeleton in an amount of 1 % by mass to 10% by mass, that contains an organic solvent that has a boiling temperature in a range of from 100°C to 300°C in an amount of equal to or less than 2% by mass, and that has a pH of 6.0 to 9.5, and evaporation-concentrating, in an evaporation-concentration apparatus, the waste liquid such that the concentration degree (an amount of the waste liquid after the concentration to an amount of the waste liquid before the concentration) is from 1/10 to 1/2 on a volume basis.

The image recording layer may contain, for example, other known components such as (d) a binder polymer.

In one embodiment, the method of concentrating a waste liquid may further include a step of condensing vapor generated in the evaporation-concentration step by cooling to produce regenerated water.

The photosensitive planographic printing plate precursor according to the invention is subjected to plate-making through a water washing step and an oil-desensitizing processing step for a non-image area with an oil-desensitizing liquid, which are subsequent to a step of subjecting an unexposed area of the above-described image recording layer to a development process, thereby providing a planographic printing plate precursor.

With the photosensitive planographic printing plate precursor according to the invention, an image recording layer on a support is exposed, the polymerizable compound (c) is cured by the function of active species generated from the polymerization initiator (b) in an exposed region, thereby forming a so-called latent image, thereafter, the unexposed region (uncured region) is removed by the development to make the cured region into an ink-receiving image area, and the unexposed region removed by the development becomes a non-image area to manufacture a planographic printing plate.

Hereinafter, the method of concentrating a waste liquid of the invention will be described in the order of steps. The photosensitive planographic printing plate precursor and the exposing step prior to the development step used will be described below.

### [Plate-Making Processing Step]

The plate-making processing of the photosensitive planographic printing plate precursor according to the invention has at least a development step (i), a water washing step (ii), and an oil-desensitizing processing step (iii) in this order, which are carried out after the exposing step. The method of concentrating a waste liquid of the invention relates to a method of concentrating the developing waste liquid produced from the development step (i) in the plate-making process. In one embodiment, the step of obtaining a waste liquid produced by a development in the method of concentrating a waste liquid of the invention may include the development step (i).

### [Development step (i)]

The photosensitive planographic printing plate precursor is exposed imagewise in the exposing step as described below, and after the exposed area is cured, the development step (i) is carried out.

### (Developer liquid)

First, a developer liquid that is preferably used in the method of concentrating a waste liquid of the invention will be described.

In the waste liquid of the invention, the developer liquid used for the development of the photosensitive planographic printing plate will be described.

Further, in the specification, unless otherwise specifically limited, the "developer liquid" has a meaning that encompasses both of a development initiating liquid (a developer liquid in a narrow sense) and a development replenisher liquid.

The developer liquid (a development initiating liquid and a development replenisher liquid) that is applied to the invention is a developer liquid that develops a photosensitive planographic printing plate precursor having a radical-polymerizable image recording layer, contains at least one surfactant selected from the group consisting of an anionic surfactant having a naphthalene skeleton and a nonionic surfactant having a naphthalene skeleton in an amount of 1 % by mass to 10% by mass with respect to a total amount of the developer liquid, and has a content of an organic solvent having a boiling temperature in a range of from 100°C to 300°C of equal to or less than 2% by mass and a pH of from 6.0 to 9.5. Here, the expression "having a content of an organic solvent having a boiling temperature in a range of from 100°C to 300°C of equal to or less than 2% by mass" is used to have a meaning to encompass a state not containing an organic solvent having a boiling temperature in a range of from 100°C to 300°C (a state where the content of the organic solvent having a boiling temperature in a range of from 100°C to 300°C is 0% by mass excluding inevitable impurities).

In one embodiment, it is preferable that the developer liquid does not substantially contain an organic solvent having a boiling temperature of lower than 100°C or higher than 300°C. Here, the expression "do not substantially contain an organic solvent having a boiling temperature of lower than 100°C or higher than 300°C" means that the content of an organic solvent having a boiling temperature of lower than 100°C or higher than 300°C is less than 0.2% by mass. It is preferable that the developer liquid according to the invention does not contain an organic solvent having a boiling temperature of lower than 100°C or higher than 300°C.

### (Surfactant Selected from Anionic Surfactant Having Naphthalene Skeleton and Nonionic Surfactant Having Naphthalene Skeleton)

The surfactant contained in the developer liquid in the invention is at least one surfactant selected from the group consisting of an anionic surfactant having a naphthalene skeleton and a nonionic surfactant having a naphthalene skeleton (hereinafter suitably referred to as a specific surfactant). In one embodiment, the specific surfactant may be a compound containing at least one selected from the group consisting of an oxyethylene group and an oxypropylene group. In one embodiment, the oxyethylene group and/or the oxypropylene group may be contained in the specific surfactant as a repeating unit forming a polyoxyalkylene chain, and a number of the repeating units may be from 5 to 30. In one embodiment, the specific surfactant may be a compound containing at least one selected from the group consisting of a polyoxyethylene chain and/or a polyoxypropylene chain.

Preferred examples of the optimal anionic surfactant having a naphthalene skeleton in the developer liquid used in the invention include a sulfonic acid salt having a naphthalene skeleton and a sulfuric acid salt having a naphthalene skeleton, and more preferred examples thereof include a naphthalene sulfonic acid salt that may have a substituent, and a compound represented by the following Formula (A).

The naphthalene sulfonic acid salt that may have a substituent preferably has 1 to 4 alkyl groups, more preferably has 1 or 2 alkyl groups, as the substitutent(s) on a naphthalene ring, and each of the alkyl groups has 1 to 20 carbon atoms. The naphthalene sulfonic acid salt preferably has 1 to 3 sulfonic acid salt(s), preferably has 1 or 2 sulfonic acid salt(s), as the substitutent(s) on a naphthalene ring. The sulfonic acid salt is preferably a sodium salt, a potassium salt, or an ammonium salt.

Specific examples thereof include sodium di-tert-butylnaphthalenesulfonate, sodium mono-tert-butylnaphthalenesulfonate, sodium di-tert-butylnaphthalenesulfonate, sodium mono-tert-butylnaphthalenedisulfonate, and a mixture thereof.

The anionic surfactant having a naphthalene skeleton is preferably an anion surfactant represented by the following Formula (A).

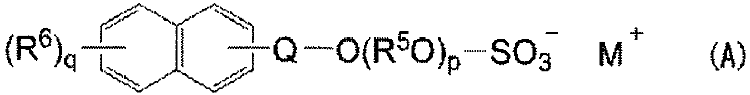

(In Formula (A), R⁵ represents a linear or branched chain alkylene group having 1 to 5 carbon atoms; R⁶ represents a linear or branched chain alkyl group having 1 to 20 carbon atoms; q represents 0, 1, or 2; Q represents a single bond or an alkylene group having 1 to 10 carbon atoms; and p represents an integer from 1 to 100. In a case in which p is 2 or more, each R⁵ may be the same as or different from each other R⁵. In a case in which q is 2 or more, each R⁶ may be the same as or different from each other R⁶. M⁺ represents Na⁺, K⁺, Li⁺, or NH⁴⁺.)

In a preferred embodiment of the invention, preferred examples of R⁵ in Formula (A) include -CH₂-, -CH₂CH₂-, -CH₂CH₂CH₂-, and -CH₂CH(CH₃)-, and more preferred examples thereof include -CH₂CH₂-. Preferred examples of R⁶ include CH₃, C₂H₅, C₃H₇, and C₄H₉. q is preferably 0 or 1. Q is preferably a single bond. p is preferably an integer from 1 to 20.

Specific examples of the compound represented by Formula (A) include the following compounds.

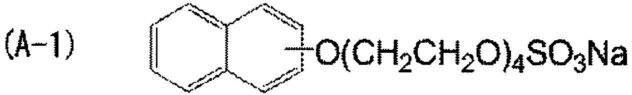

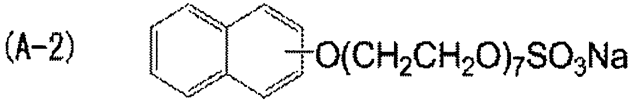

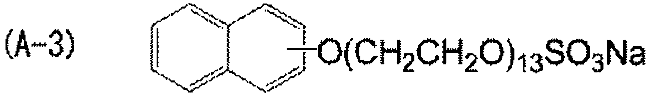

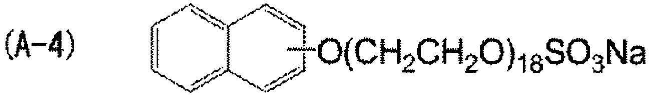

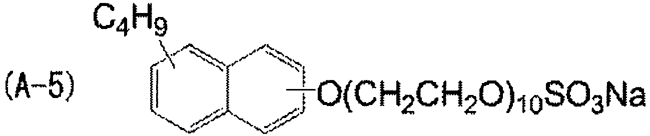

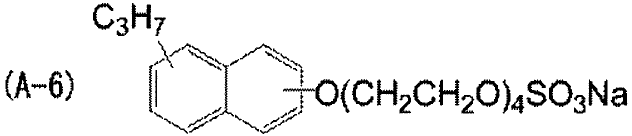

The nonionic surfactant having a naphthalene skeleton is preferably a surfactant represented by the following Formula (B).

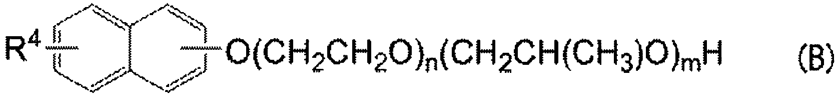

(In Formula (B), R⁴ represents a hydrogen atom or an alkyl group having 1 to 100 carbon atoms. n and m are each independently an integer from 0 to 100, provided that n and m are not simultaneously 0.)

Preferred examples of the compound represented by Formula (B) include polyoxyethylene naphthyl ether, polyoxyethylene methyl naphthyl ether, polyoxyethylene octyl naphthyl ether, and polyoxyethylene nonyl naphthyl ether.

In the compound represented by Formula (B), the number (n) of oxyethylene groups that are the repeating units is preferably from 3 to 50, and more preferably from 5 to 30, and the number (m) of oxypropylene groups that are the repeating units is preferably from 0 to 10, and more preferably from 0 to 5. In the case in which plural oxyethylene groups and oxypropylene groups are connected with each other to form a chain-shaped polyoxyalkylene chain, the oxyethylene groups and the oxypropylene groups may form a random copolymer or a block copolymer, and in the case in which the number of oxyethylene groups is from 3 to 50, the number of oxypropylene groups is preferably from 1 to 10. In one embodiment, the sum of the number of oxyethylene groups and oxypropylene groups that are repeating units contained in the polyoxyalkylene chain is preferably from 5 to 30. In one embodiment, in the case in which no oxyethylene groups is contained and only oxypropylene groups are contained in the polyoxyalkylene chain (that is, n is 0), m is preferably from 1 to 10.

The nonionic surfactants represented by Formula (B) may be used singly or in combination of two or more kinds thereof.

Specific examples of the compound represented by Formula (B) are set forth below.

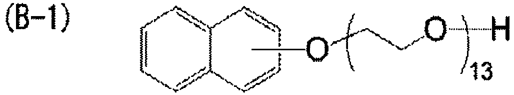

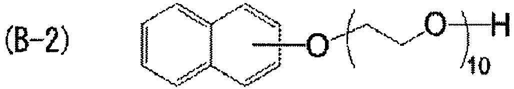

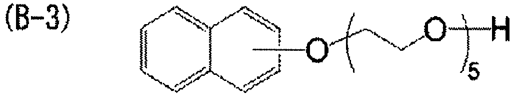

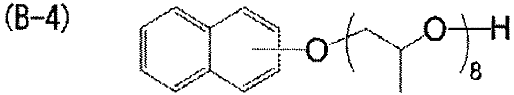

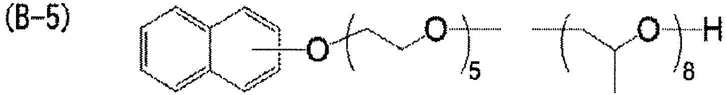

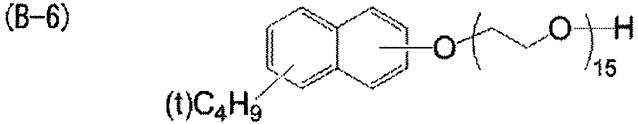

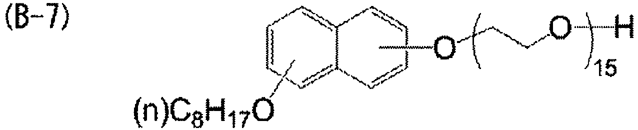

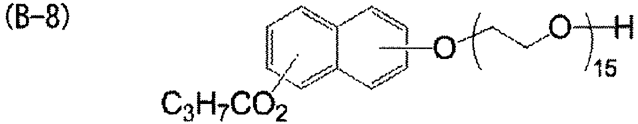

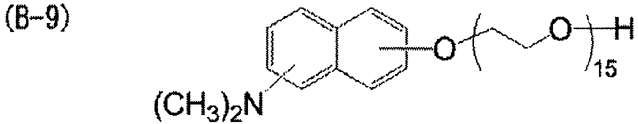

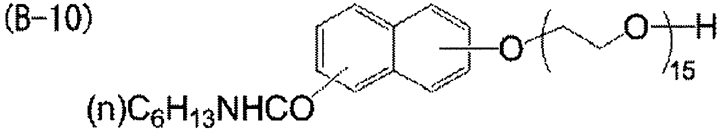

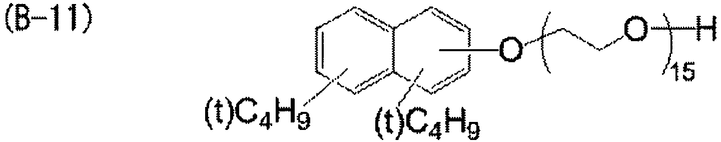

The specific surfactants that are employed in the developer liquid used in the invention may be used singly or in combination of two or more kinds thereof.

A content of the specific surfactant in the developer liquid is in a range of 1% by mass to 10% by mass, and preferably in a range of 2% by mass to 10% by mass. If the content is 1 % by mass or more, the developability and the solubility of the components in the image recording layer of an unexposed area are good, and by setting the content to 10% by mass or less, the printing durability of a planographic printing plate thus obtained is improved.

As described above, the "developer liquid" herein used as one that has a meaning to encompass a development replenisher liquid, and from such a viewpoint, the content of the specific surfactant that is employed in the development replenisher liquid used in the invention is preferably in a range of 1 % by mass to 10% by mass.

### (Organic Solvent)

The developer liquid (the development initiating liquid and the development replenisher liquid) used in the invention has a content of an organic solvent having a boiling temperature in a range of from 100°C to 300°C of equal to or less than 2% by mass, and as described above, the organic solvent may not be contained therein. That is, the organic solvent acceptable to be contained in the developer liquid according to the invention is an organic solvent having a boiling temperature in a range of from 100°C to 300°C and the upper limit of its acceptable content is 2% by mass.

An organic solvent having a boiling temperature of lower than 100°C is easily volatilized and thus has a tendency of lesser stability. If an organic solvent having a boiling temperature higher than 300°C is contained in the developer liquid, it becomes more difficult to concentrate the waste liquid. As a result, it is preferable that the developer liquid according to the invention does not contain an organic solvent which is different from the above-mentioned organic solvent, except for one that is an inevitable impurity.

Any organic solvent may be used as the organic solvent included in the developer liquid, as long as the boiling point is in a range of from 100°C to 300°C, and preferred examples thereof include 2-phenylethanol (boiling point: 219°C), 3-phenyl-1-propanol (boiling point: 238°C), 2-phenoxyethanol (boiling point: 244°C to 255°C), benzyl alcohol (boiling point: 205°C), cyclohexanol (boiling point: 161 °C), monoethanolamine (boiling point: 170°C), diethanolamine (boiling point: 268°C), cyclohexanone (boiling point: 155°C), ethyl lactate (boiling point: 155°C), propylene glycol (boiling point: 187°C), ethylene glycol (boiling point: 198°C), γ-butyrolactone (boiling point: 205°C), N-methylpyrrolidone (boiling point: 202°C), N-ethylpyrrolidone (boiling point: 218°C), glycerin (boiling point: 290°C), propylene glycol monomethyl ether (boiling point: 120°C), ethylene glycol monomethyl ether (boiling point: 124°C), ethylene glycol monomethyl ether acetate (boiling point: 145°C), diethylene glycol dimethyl ether (boiling point: 162°C), and glycerin (boiling point: 299°C), and particularly preferred examples include benzyl alcohol, diethanolamine, monoethanolamine, γ-butyrolactone, N-methylpyrrolidone, and N-ethylpyrrolidone.

The amines of the alkali agent that will be described below are also handled as organic solvents in the invention, as long as the boiling points thereof are in the range of from 100°C to 300°C.

### (Organic acid or Salt thereof)

The pH of the developer liquid, which has a pH value of from 6.0 to 9.5, may be adjusted using a pH adjusting agent. It is preferable that the developer liquid contains, as the pH adjusting agent, an organic carboxylic acid such as citric acid, malic acid, tartaric acid, gluconic acid, benzoic acid, phthalic acid, p-ethylbenzoic acid, p-n-propylbenzoic acid, p-isopropylbenzoic acid, p-n-butylbenzoic acid, p-t-butylbenzoic acid, p-t-butylbenzoic acid, p-2-hydroxyethylbenzoic acid, decanoic acid, salicylic acid or 3-hydroxy-2-naphthoic acid, or a metal salt, ammonium salt, or the like thereof. Among them, citric acid has a function as a buffering agent, and citric acid is added as, for example, trisodium citrate or tripotassium citrate. In general, one kind or two or more kinds of the buffering agents are incorporated into the developer liquid in an amount in a range of from 0.05% to 5% by mass, and more preferably from 0.3% to 3% by mass.

The developer liquid may include a chelating agent for a divalent metal. Examples of the divalent metal include magnesium and calcium. Examples of the chelating agent for a divalent metal include: polyphosphoric acid salts such as Na₂P₂O₇, Na₅P₃O₃, Na₃P₃O₉, Na₂O₄P(NaO₃P)PO₃Na₂, and CALGON (poly(sodium metaphosphate)); aminopolycarboxylic acids such as ethylenediaminetetraacetic acid and potassium salts thereof and sodium salts thereof, diethylenetriaminepentaacetic acid and potassium salts thereof and sodium salts thereof, triethylenetetraminehexaacetic acid and potassium salts thereof and sodium salts thereof, hydroxyethylethylenediaminetriacetic acid and potassium salts thereof and sodium salts thereof, nitrilotriacetic acid and potassium salts thereof and sodium salts thereof, 1,2-diaminocyclohexanetetraacetic acid and potassium salts thereof and sodium salts thereof, and 1,3-diamino-2-propanoltetraacetic acid and potassium salts thereof and sodium salts thereof; and organic phosphonic acids such as 2-phosphonobutane-1,2,4-tricarboxylic acid and potassium salts thereof and sodium salts thereof, 2-phosphonobutanone-2,3,4-tricarboxylic acid and potassium salts thereof and sodium salts thereof, 1-phosphonoethane-1,2,2-tricarboxylic acid and potassium salts thereof and sodium salts thereof, 1-hydroxyethane-1,1-diphosphonic acid and potassium salts thereof and sodium salts thereof, and aminotri(methylenephosphonic acid) and potassium salts thereof and sodium salts thereof.

A content of these chelating agents may vary with the hardness of water to be used and the amount of water to be used. In general, a content ratio of the chelating agent in the developer liquid at the time of use is preferably in a range of from 0.01% by mass to 5% by mass, and more preferably in a range of from 0.01% by mass to 0.5% by mass.

When an anionic surfactant is contained in the developer liquid, the developer liquid may easily foam in some cases. Therefore, the developer liquid may further include a defoamer. When the developer liquid includes a defoamer, the defoamer is preferably contained in the developer liquid at a ratio of 0.00001% by mass or higher, and more preferably at a ratio of from about 0.0001% by mass to about 0.5% by mass, with respect to the developer liquid.

Examples of the defoamer that can be used in the developer liquid according to the invention include a fluorine-containing defoamer, a silicone-containing defoamer, an acetylene alcohol, and an acetylene glycol.

Examples of the fluorine-containing defoamer include a compound represented by the following formula.

Among the examples of the fluorine-containing defoamer, fluorine-containing defoamers having an HLB value of from 1 to 9, in particular fluorine-containing defoamers having an HLB value of from 1 to 4, are preferable. The fluorine-containing defoamer described above is added, as it is, to the developer liquid or added, in the form of an emulsion liquid mixed with water or a solvent other than water, to the developer liquid.

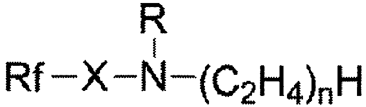

In the formula, R represents H or an alkyl group; Rf represents a fluoroalkyl group (having from about 5 to about 10 carbon atoms) in which some or all of H atoms of its alkyl group are substituted with F atoms; X represents CO or SO₂; and n represents an integer from about 1 to about 10.

Examples of the silicone-containing defoamer include: dialkylpolydioxane, preferably dimethylpolydioxane shown by the following Formula (S-1) itself, or the dimethylpolydioxane of Formula (S-1) formed into an O/W emulsion liquid; the alkoxypoly(ethyleneoxy)siloxane shown by the following Formula (S-2) or Formula (S-3); a product obtained by modifying dimethylpolydioxane by introduction of carboxylic acid groups or sulfonic acid groups into parts of the dimethylpolydioxane; and an emulsion liquid obtained by mixing any of these silicone compounds with water and a generally known anionic surfactant. 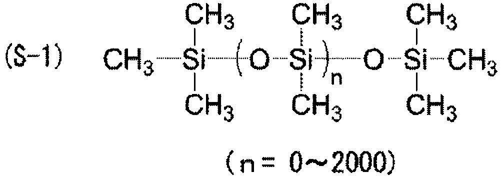 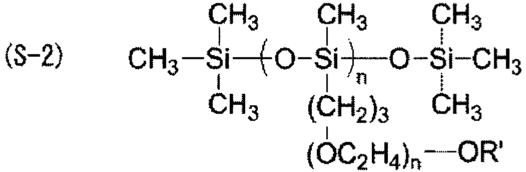 (n: 6 to 10; R': lower alkyl of C₁ to C₄) 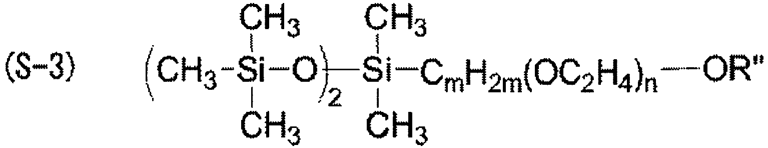 (m: 2 to 4; n: 4 to 12; R": lower alkyl of C₁ to C₄)

An acetylene alcohol which can be used as the defoamer is an unsaturated alcohol having an acetylene bond (triple bond) in a molecule thereof. An acetylene glycol is also referred to as an alkylene diol, and is an unsaturated glycol having an acetylene bond (triple bond) in a molecule thereof.

More specifically, examples thereof include compounds represented by the following Formula (A-1) and compounds represented by the following Formula (A-2).

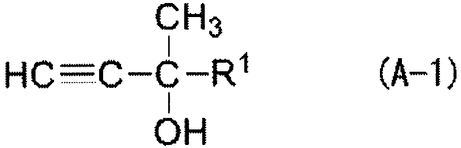

In Formula (A-1), R¹ represents a straight- or branched- chain alkyl group having from 1 to 5 carbon atoms.

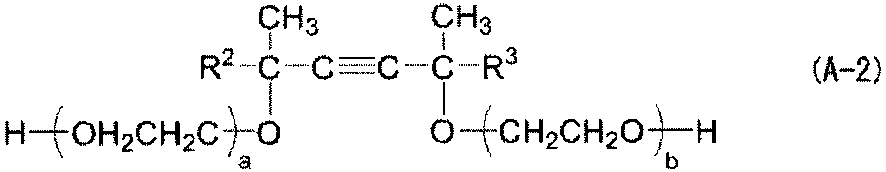

In Formula (A-2), each of R² and R³ independently represents a straight- or branched-chain alkyl group having from 1 to 5 carbon atoms; and each of a and b independently represents an integer of 0 or greater, provided that a + b is in a range of from 0 to 30.

In Formula (A-2), examples of the straight- or branched- chain alkyl group having from 1 to 5 carbon atoms include a methyl group, an ethyl group, an isopropyl group, an isobutyl group, and an isopentyl group.

Specific examples of acetylene alcohols and acetylene glycols further include the following:
(1) propargyl alcohol
(2) propargyl carbinol
(3) 3,5-dimethyl-1-hexyn-3-ol
(4) 3-methyl-1-butyn-3-ol
(5) 3-methyl-1-pentyn-3-ol
(6) 1,4-butynediol
(7) 2,5-dimethyl-3-hexyne-2,5-diol
(8) 3,6-dimethyl-4-octyne-3,6-diol
(9) 2,4,7,9-tetramethyl-5-decyne-4,7-diol
(10) ethylene oxide adduct of 2,4,7,9-tetramethyl-5-decyne-4,7-diol (structure shown below). 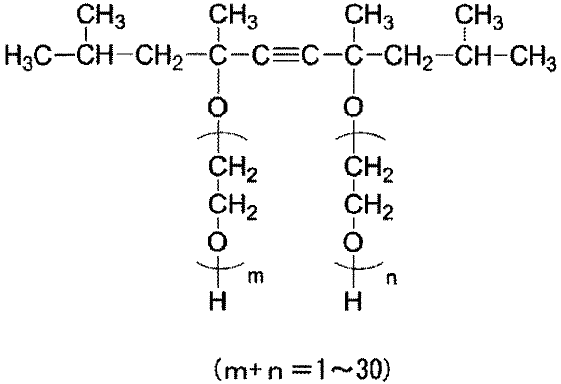
(11) 2,5,8,11-tetramethyl-6-dodecyne-5,8-diol

These acetylene alcohols and acetylene glycols are available from the market, and examples of known commercial products include trade name SURFINOL series of Air Products and Chemicals, Inc., and trade name OLFINE series manufactured by Nisshin Chemical Co., Ltd. Specific examples of commercially available products include SURFINOL 61 (trade name), which is the compound (3) above; OLFINE B (trade name), which is the compound (4) above; OLFINE P (trade name), which is the compound (5) above; OLFINE Y (trade name), which is the compound (7) above; SURFINOL 82 (trade name), which is the compound (8) above; SURFINOL 104 (trade name) and OLFINE AK-02 (trade name), which are the compound (9) above; SURFINOL 400 series (trade name), which are the compound (10) above; and SURFINOL DF-110 (trade name), which is the compound (11) above.

The developer liquid used in the invention may include, as a development adjusting agent, an alkali metal salt of an organic acid and/or an alkali metal salt of an inorganic acid. For example, the developer liquid may include one selected from, or a combination of two or more selected from, sodium carbonate, potassium carbonate, ammonium carbonate, sodium citrate, potassium citrate, and ammonium citrate, and the like.

The developer liquid may include, as an alkali agent, one selected from, or a combination of two or more selected from: inorganic alkali agents such as trisodium phosphate, tripotassium phosphate, triammonium phosphate, sodium borate, potassium borate, ammonium borate, sodium hydroxide, potassium hydroxide, ammonium hydroxide, and lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide.

The developer liquid according to the invention may further contain, in addition to these components, for example, a component selected from a chelating agent, a reducing agent, a dye, a pigment, a water softener, and a preservative, if necessary.

Further, since the photosensitive planographic printing plate precursor to which the method of the invention is applied is subjected to water washing and oil-desensitizing after development, it is not necessary for the developer liquid to contain a water-soluble polymer compound or the like for the purpose of protecting a plate surface; and from the viewpoint of improving the efficiency of the concentration of the developing waste liquid, it is preferable that the water-soluble polymer compound be not contained.

The pH of the developer liquid may be in a range of from 6.0 to 9.5, and is preferably in a range of from 8.0 to 9.0.

The developer liquid used in the invention may include an alkali metal salt of an organic acid and /or an alkali metal salt of an inorganic acids as a conductivity adjusting agent for adjusting conductivity.

### (Water)

The component occupying the remaining part of the developer liquid or the positive developer liquid described above is water. The developer liquid according to the invention may be prepared in the form of a developer stock solution. That is, it is beneficial, in terms of transport, to prepare the developer liquid according to the invention as a concentrate liquid in which the content of water is smaller than that at the time of use, and to dilute the concentrate liquid with water at the time of use. A degree of concentration appropriate in this case is a concentration at which each of the components does not separate or precipitate.

The developer liquid can be used as a development initiating liquid and a development replenisher liquid for an exposed photosensitive planographic printing plate precursor, and it is preferably applied in a development bath of an automatic processing apparatus as described above.

In a case in which development is performed using an automatic processing apparatus, the developer liquid deteriorates according to the processing amount, and therefore, the developer liquid may be replenishment with a replenishment liquid or a fresh developer liquid to recover its development processing ability. Also in the recycling method of the invention as described below, this replenishment mode is preferably applied.

The development process may be preferably carried out by an automatic processing apparatus equipped with a means for supplying a developer liquid (supplying member) and a rubbing member.

Further, prior to the development process, a pre-processing step in which a water washing processing is carried out in advance to remove the protective layer may be carried out.

After the development process, a water washing step (ii) is carried out as described below. Herein, a water washing step may be carried out after removing an excessive developer liquid using a squeeze roller.

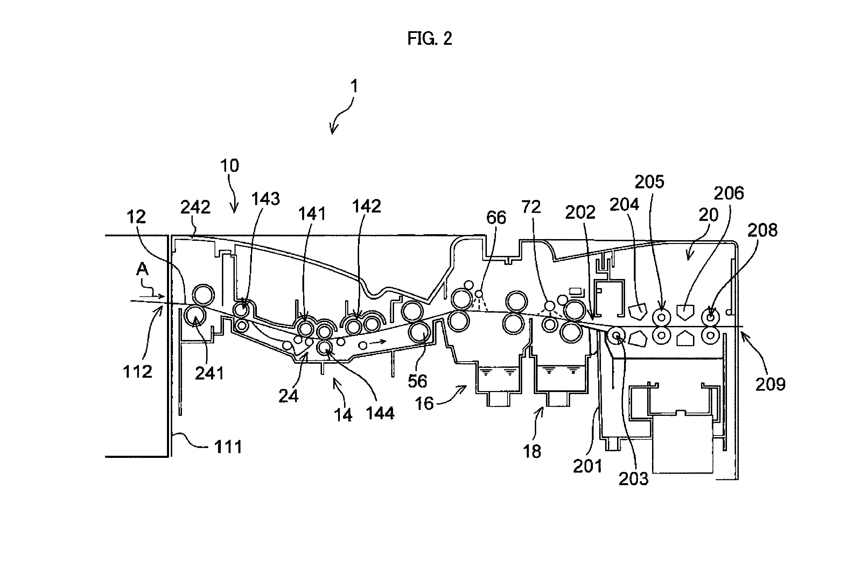

One example of the automatic development processing apparatus will be briefly described with reference to Fig. 2.

An automatic development apparatus 1 shown in Fig. 2 has a development processing unit 10, and also has a development unit 14, a water washing unit 16, and an oil-desensitizing processing unit 18, and a drying unit 20, which are successively formed along a direction (arrow A) of a transportation path 12 for transporting a planographic printing plate precursor.

The development unit 14 is partitioned by an outer panel 111 and an insertion slot 112 in a slit shape is provided in the outer panel 111.

In the development unit 14, a developing tank 24 filled with a developer liquid and a pair of insertion rollers 241 for guiding a planographic printing plate precursor into the developing tank 24 are provided. A shielding cover 242 is located above the developing tank 24.

In the developing tank 24, a guide roller 143, a guide member, a brush roller 141, an in-liquid transporting roller 144, a brush roller 142, and a development unit outlet roller are provided together in this order from the upstream side in the transport direction. A planographic printing plate precursor transported into the developing tank 24 is immersed in the developer liquid and passed between the rotating brush rollers 141 and 142 to remove a non-image area.

The planographic printing plate taken from the developing tank 24 is supplied with washing water by a water washing spray 66 in the water washing unit 16, the developer liquid remaining on the plate surface or the like is removed by water washing, and then an oil-desensitizing processing liquid is supplied to the plate surface by a spray 72 that supplies a gum liquid (oil-desensitizing processing liquid) in an oil-desensitizing processing unit 18.

In a partition board 201 disposed between the development processing unit 10 and the drying unit 20, a pass-through slot 202 which has a slit type is provided. Further, a shutter (not shown) is provided along a passage between the development processing unit 10 and the drying unit 20 and the passage is closed by the shutter when a planographic printing plate precursor does not pass through the passage.

In the drying unit 20, a support roller 203, a duct 204, a pair of transport rollers 205, a duct 206, and a pair of transport rollers 208 are provided in this order. A slit hole is provided at the top of the ducts 204 and 205. Further, in the drying unit 20, a drying means (drying member) such as a warm air supplying means (warm air supplying member) and a heat generating means (heat generating member), not shown, are provided. In the drying unit 20, a discharge slot 209 is provided. A planographic printing plate dried by the drying means is discharged from the discharge slot 209.

The photosensitive planographic printing plate precursor is subjected to the development step (i) and then to a water washing processing in the water washing unit 16 of the automatic developing machine [Water Washing Step (ii)].

### [Water Washing Step (ii)]

The water washing step is a step of washing, with water, a plate in which a protective layer and an image recording layer corresponding to an unexposed area are removed by a developer liquid. The water may be water directly supplied from water service, or water stored in a tank. Regenerated water obtained by the method of recycling a waste liquid produced by a development of the invention as described below may be stored in a tank and used in the water washing step.

The washing water is usually sprayed from a water washing spray 66 provided in the water washing unit 16 to a planographic printing plate precursor that has been processed in the development step.

A planographic printing plate is obtained by subjecting the planographic printing plate precursor that has been subjected to the development step and the water washing processing step to an oil-desensitizing processing liquid in an oil-desensitizing processing unit 18 [Oil-Desensitizing Step (iii)] for plate-making.

### [Oil-Desensitizing Processing Step (iii)]

The photosensitive planographic printing plate in which the image recording layer in an unexposed area (non-image) is removed by a development process and a water washing process is subjected to a post-process with an oil-desensitizing liquid including a water-soluble polymer compound such as gum arabic and a starch derivative, as described in Japanese Patent Application Laid-Open (JP-A) Nos. S54-8002, S55-115045, and S59-58431, and the like.

That is, in the oil-desensitizing processing step (iii), an oil-desensitizing processing liquid is supplied to a surface of the plate, and a surface of the non-image area region undergoes oil-desensitizing processing using an oil-desensitizing processing liquid supplying spray 72. When the non-image area surface is oil-desensitizing processed, the hydrophilicity of the non-image area surface in the planographic printing plate is suitably maintained, and thus, generation of dirt in the non-image area is suppressed, thereby improving the printing durability of the planographic printing plate. Further, by applying the oil-desensitizing processing liquid to the image area surface, the scratch resistance of the image area is further improved.

In the invention, examples of the water-soluble polymer compound for use in the preparation of the oil-desensitizing processing liquid include soybean polysaccharides, modified starch, gum arabic, dextrin, a cellulose derivative (for example, carboxymethyl cellulose, carboxyethyl cellulose, and methyl cellulose) or a modified product thereof, pullulan, a polyvinyl alcohol, or derivatives thereof, polyvinyl pyrrolidone, a polyacrylamide, an acrylamide copolymer, a vinyl methyl ether/maleic anhydride copolymer, a vinyl acetate/maleic anhydride copolymer, and a styrene/maleic anhydride copolymer. A preferred acid value of the water-soluble polymer compound is from 0 meq/g to 3.0 meq/g.

### [Evaporation-concentration Step]

In the step, the waste liquid produced by plate-making produced in the plate-making processing step (i) is subjected to evaporation-concentration in an evaporation-concentration apparatus such that the degree of concentration (amount of a waste liquid produced by plate-making after concentration/amount of a waste liquid produced by plate-making before the concentration) on a volume basis is from 1/10 to 1/2 on a volume basis.

Hereinafter, the evaporation-concentration step according to the invention will be described.

The evaporation-concentration apparatus includes at least an evaporation pot that heats the waste liquid, with or without reducing pressure so as to separate the liquid into evaporated moisture and a residual concentrated matter (slurry). In a preferred embodiment, the evaporation-concentration apparatus further include a cooling pot, into which the moisture separated in the evaporation pot as water vapor that may contain an organic solvent is introduced, and which condenses the water vapor by cooling to obtain regenerated water.

It is preferable that the concentrating of the waste liquid is performed by a method including heating and concentrating the waste liquid while reducing pressure inside the evaporation pot using a pressure reducing means (pressure reducing device). This is because this method decreases the boiling temperature of the waste liquid and enables the waste liquid to be concentrated by evaporation at a temperature lower than that under atmospheric pressure. Since the use of the pressure reducing means enables the concentrating by evaporation to be carried out with higher safety at a lower temperature, there is an advantage in that the evaporation pot, the waste liquid and waste liquid concentrated matter are less likely to be affected by heat.

Examples of pressure reducing means include: general mechanical vacuum pumps such as a water seal vacuum pump, an oil rotation vacuum pump, and a diaphragm vacuum pump; diffusion pumps utilizing oil or mercury; compressors such as a multistage turbo compressor, a reciprocal compressor and a screw compressor; and an aspirator. Among these, an aspirator is preferable from the viewpoints of maintainability and cost.

In regard to the pressure reduction conditions, for example, the pressure may be reduced so as to adjust the pressure to be in a range of from 666.9 Pa (5 mmHg) to 13332.2 Pa (100 mmHg), and preferably in a range of from 666.9 Pa (5 mmHg) to 3999.7 Pa (30 mmHg).

In regard to the heating conditions, a temperature range corresponding to a pressure of from 666.9 Pa (5 mmHg) to 13332.2 Pa (100 mmHg), which can be easily achieved using a water-jet pump or a vacuum pump, is selected. Specifically, the heating temperature is, for example, in a range of from 20°C to 80°C, and more preferably in a range of from 25°C to 45°C.

When the concentrating is performed by distilling at a high temperature without reducing pressure, more electric power is required in this case. The heating temperature can be lowered, and the electric power usage can be regulated, by performing the concentrating under reduced pressure as described above.

Use of a heat pump as a heating means (heating member) in the evaporation pot is also a preferable mode. The heat pump preferably includes a heat releasing unit and a heat absorbing unit. In this case, it is possible to heat the waste liquid produced by plate-making at the heat releasing unit of the heat pump, and to cool the water vapor at the heat absorbing unit of the heat pump. That is, concentration of the waste liquid by heating is carried out using heat release from the heat pump and condensation of the water vapor in the cooling means is carried out by heat adsorption by the heat pump, and thus, the thermal efficiency is good. Further, it is advantageous in terms of prevention of occurrence of local high temperatures, provision of higher safety, and reduction in the amount of carbon dioxide discharged, and the like, as compared to the case in which a heating means such as an electrical heater is used.

In the evaporation-concentration apparatus, when the waste liquid produced by plate-making is subjected to evaporation-concentration, the waste liquid produced by plate-making is heated by the heating means in the evaporation pot, thereby being evaporated and concentrated such that a degree of concentration (an amount of the waste liquid after concentration/an amount of the waste liquid before the concentration) is a ratio of from 1/10 to 1/2 on a volume basis. Here, when the degree of concentration is 1/2 or more, the amount of the waste liquid to be processed is reduced more efficiently, whereas when the degree of concentration is 1/10 or less, precipitation of solids in the waste liquid concentrated in the evaporation pot of the waste liquid concentration apparatus 30 becomes less likely to occur, and the maintainability is improved. The degree of concentration is preferably in a range of from 1/8 to 1/3. With the degree of concentration being within this range, dirt in the concentration pot may become less, and continuous operation can be performed over a long period of time. Further, the obtained regenerated water can be reutilized, and therefore, the amount of the waste liquid that is disposed of as a waste liquid produced by plate-making is extremely small.

As the waste liquid concentration apparatus for use in the present embodiment, a commercially available product such as heat pump type apparatuses XR-2000 and XR-5000 (both trade names, Fujifilm Global Graphic Systems Co., Ltd.), and a heating mode FRIENDLY series (trade name) manufactured by Cosmotec Co., Ltd. may be used.

### [Regenerated Water Producing Step]

In the step, water vapor generated during the evaporation-concentration is condensed by cooling to produce regenerated water.

In the evaporation-concentration step, in the case in which the heating concentration of the waste liquid is carried out by a heat pump as described above, the water vapor cooled in the heat absorbing unit of the heat pump becomes a liquid, and thus, regenerated water is obtained. That is, in the evaporation-concentration step, regenerated water is produced.

In addition, in the case in which heating concentration of the waste liquid is carried out using a known heating means such as an electrical heater, regenerated water can be produced by extracting the water vapor from the evaporation-concentration apparatus, and condensing the water vapor using a cooling means (cooling member). As the cooling means, a known water-cooling cooler or the like may be suitably used.

Regenerated water thus obtained is regenerated water having low BOD and COD values. In the case in which the developer liquid for use in the invention is used, the BOD value of regenerated water is usually 250 mg/L or less, and the COD value of regenerated water is 200 mg/L or less. Thus, a surplus of regenerated water may be discharged as it is to common drainage. However, in the case in which regenerated water contains an organic solvent or the like, processing by activated sludge or the like is carried out before discharging.

Furthermore, as in a recycling method of the invention as described below, preferably, regenerated water is reutilized by being supplied as diluent water to the development bath or supplied as washing water in the water washing unit 16.

### [Method of recycling Waste liquid produced by plate-making of Photosensitive Planographic Printing Plate]

In the plate-making of a photosensitive planographic printing plate precursor for generating a waste liquid that is applied to the method of concentrating a waste liquid of the invention, a photosensitive planographic printing plate precursor having, on a support, a negative type image recording layer, which is described below in detail, is exposed, and then subjected to: (i) a development step which uses a processing liquid which contains i) at least one surfactant selected from the group consisting of an anionic surfactant having a naphthalene skeleton and a nonionic surfactant having a naphthalene skeleton in an amount of 1% by mass to 10% by mass, which contains an organic solvent that has a boiling temperature in a range of from 100°C to 300°C in an amount of equal to or less than 2% by mass, and which has a pH of 6.0 to 9.5; (ii) a water washing step; and (iii) an oil-desensitizing processing step for a non-image area with an oil-desensitizing liquid are carried out as described above.

The recycling method, that is one embodiment of the invention, includes a step of evaporation-concentrating, in the evaporation-concentration apparatus, the waste liquid that is produced by the development step, such that a ratio of the volume of the waste liquid after concentration to the volume of the waste liquid before the concentration (degree of concentration, that is (an amount of the waste liquid after concentration)/(an amount of the waste liquid before the concentration) on a volume basis) is from 1/10 to 1/2, a step of producing regenerated water in which the water vapor generated in the evaporation-concentration step is condensed by cooling to produce the regenerated water, and a step of supplying regenerated water in which regenerated water is supplied to the automatic developing machine.

That is, the recycling method of the invention further has a regenerated water supplying step, in addition to the plate-making processing step, the waste liquid evaporation-concentration step, and regenerated water producing step.

In the recycling method of the invention, the produced regenerated water may be supplied to a replenishment water tank or the like and used as diluent water for diluting the development replenisher liquid to a certain ratio in a development bath disposed in the automatic developing machine, or may be mixed with a development replenisher liquid in advance and used to dilute the development replenisher liquid to a certaincertain ratio. Further, regenerated water may be supplied to the water washing unit 14 of the automatic developing machine 1 and used as washing water. In addition, regenerated water may be supplied to an oil-desensitizing processing liquid tank in the oil-desensitizing processing unit 16.

Specific examples of apparatuses for the method of waste liquid concentration and the method of recycling plate-making process waste liquid that can be suitably used in the invention include a planographic printing plate plate-making process waste liquid reducing apparatus disclosed in Japanese Patent No. 4774124, and a waste liquid processing apparatus disclosed in, for example, JP-A No. 2011-90282.

An exemplary embodiment according to the invention is described below with reference to the drawing.

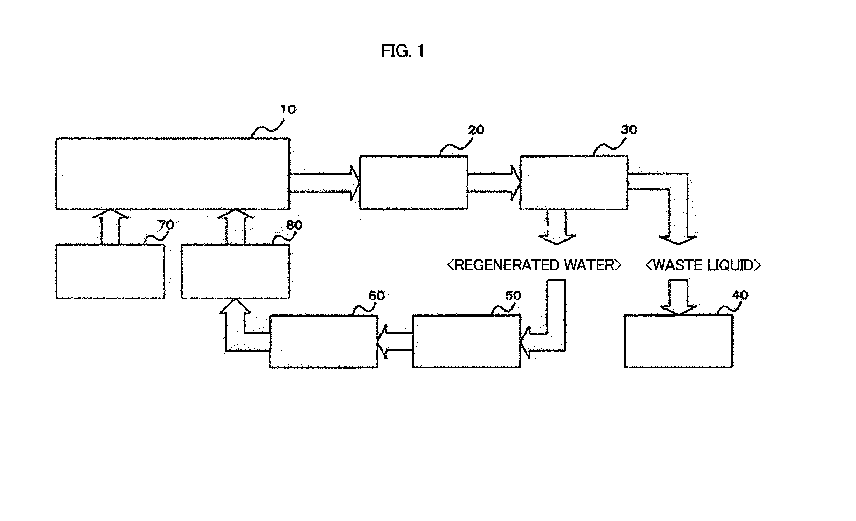

In a method of recycling a development process waste liquid according to an exemplary embodiment, as illustrated in Fig. 1, a waste liquid of a developer liquid that is discharged from an automatic developing machine 10 due to a plate-making process for a photosensitive planographic printing plate is stored in an intermediate tank 20, and the waste liquid sent from the intermediate tank 20 is heated by a waste liquid concentration apparatus 30 under either reduced pressure or without reduction of pressure, thereby separating the waste liquid into evaporated moisture and remaining concentrated matter (slurry). Regenerated water obtained by cooling and condensing the moisture that has been separated as water vapor in the waste liquid concentration apparatus 30 is introduced into a regeneration water tank 50. The waste liquid concentrated in the waste liquid concentration apparatus 30 is recovered in a waste liquid tank 40. The transfer of the waste liquid that has been concentrated in the waste liquid tank 40 is preferably carried out by applying pressure using a pump.

The evaporation-concentration apparatus 30 that concentrates a waste liquid includes at least: an evaporation pot (not shown in the figure) that heats the waste liquid, which has been sent from the intermediate tank 20, under reduced pressure so as to separate the waste liquid into evaporated moisture and residual concentrated matter (slurry); and a cooling pot (not shown in the figure) into which the moisture, which has been separated as water vapor in the evaporation pot, is introduced and which condenses the moisture by cooling to obtain regenerated water.

In the method of recycling a development process waste liquid according to the present exemplary embodiment, a regenerated water tank 50 that temporarily stores the separated regenerated water, and a distillation-regenerated water reutilization apparatus 60 that controls the supply of the regenerated water to the automatic developing machine 10 are further employed. The distillation-regenerated water reutilization apparatus 60 is preferably connected, via piping, to a replenishment water tank 80 for supplying the regenerated water to the automatic developing machine 10. The piping that connects the replenishment water tank 80 and the development bath of the automatic developing machine 10 is preferably provided with a pressure gauge for measuring pressure inside the piping, and a pump. The distillation-regenerated water reutilization apparatus 60 may include an analytic apparatus that analyzes the components of the regenerated water and a means (unit) for formulating a composition by performing a process such as the adjustment of pH by neutralization of the regenerated water, or supply of fresh water to the regenerated water in accordance with the components.

Driving of the pump is controlled in accordance with the value of the pressure measured with the pressure gauge, and the recovered regenerated water is supplied certaincertainfrom the replenishment water tank 80 to the automatic developing apparatus 10. Further, a development replenisher liquid is supplied from a development replenisher liquid tank 70 to the automatic developing machine 10.

Regenerated water obtained in this system may include an organic solvent as long as a content of the organic solvent is 0.5% by volume or less on a volume basis.

Regenerated water obtained in this system is regenerated water having low BOD and COD values. In the case in which the developer liquid for use in the invention is used, the BOD value of regenerated water obtained in the system is usually 250 mg/L or less, and the COD value of regenerated water is usually 200 mg/L or less. Therefore, the regenerated water can be used as diluent water for compensation by evaporation, diluent water of a development replenisher liquid, a rinse water for washing a plate, or washing water for an automatic developing machine, and a surplus of the regenerated water may be discharged as it is to common drainage.

In the invention, the development replenisher liquid is diluted and supplied to the development bath of the automatic developing machine 10. In the system illustrated in Fig. 1, an embodiment may be adopted in which the development replenisher liquid is diluted at a certain ratio in the development bath (not shown in the figure) disposed inside the automatic developing machine 10, with the amount of the regenerated water supplied from the replenishment water tank 80 being controlled in accordance with the amount of the development replenisher liquid supplied from the development replenisher liquid tank 70. However, the invention is not limited to this embodiment, and the development replenisher liquid and the regenerated water may be mixed so as to dilute the development replenisher liquid at a certain ratio, and then the diluted development replenisher liquid may be supplied into the development bath.

Further, the waste liquid produced by plate-making produced from plural automatic developing machines may be collected in a single waste liquid concentration apparatus, and the obtained regenerated water may be supplied as diluent water or rinse water to plural automatic developing machines.

As described above, by using regenerated water as replenishment water, an amount of a planographic printing plate precursor to be suitably subjected to a plate-making process increases without supplying dilution water or the like to the automatic developing machine.

### [Photosensitive Planographic Printing Plate Precursor]

The photosensitive planographic printing plate precursor according to the invention has: a radical-polymerizable image recording layer containing an infrared absorbing dye (a), a polymerization initiator (b), and a polymerizable compound (c); and a protective layer in this order on a support.

Each of the components included in the image recording layer will be sequentially described.

### [(a) Infrared-Absorbing Dye]

The infrared absorbing dye is a dye having a function of converting infrared rays absorbed into heat and a function of exciting by infrared rays and causes electron-shift and/or energy-shift by a radical polymerization initiator as described below. The infrared absorbing dye for use in the invention is preferably a dye having a maximum absorption at a wavelength of from 760 nm to 1200 nm.

Commercially available dyes and known dyes disclosed in, for example, the literature such as "Senryo-Binran" (Handbook of Dyes) edited by Yu-ki Go-sei Kagaku Kyokai (the Association of Organic Synthetic Chemistry) and published in 1970 may be used as dyes. Specific examples of dyes include azo dyes, metal complex salt azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts, and metal thiolate complexes.

Particularly preferable examples among these include cyanine dyes, squarylium dyes, pyrylium salts, nickel thiolate complexes, and indolenine cyanine dyes. Cyanine dyes and indolenine cyanine dyes are further preferable, and further particularly preferable examples include indolenine cyanine dyes represented by the following Formula (e).

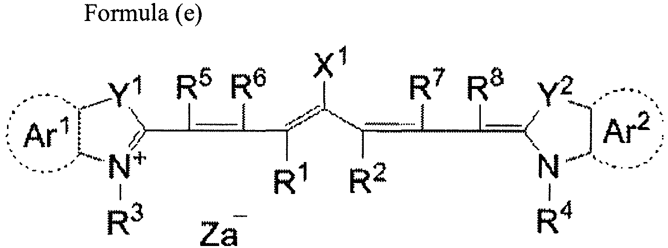

In Formula (e), X¹ represents a hydrogen atom, a halogen atom, -N(R⁹)(R¹⁰), -X²-L¹, or a group set forth below. Here, R⁹ and R¹⁰ may be the same as or different from each other, and respectively represent an aryl group having 6 to 10 carbon atoms or an alkyl group having 1 to 8 carbon atoms, each of which may have a substituent, or a hydrogen atom. R⁹ and R¹⁰ may be bonded to each other to form a ring.

Among those, a phenyl group (-NPh₂) is preferred. X² represents an oxygen atom or a sulfur atom, and L¹ represents a hydrocarbon group having 1 to 12 carbon atoms, a heteroaryl group, or a hydrocarbon group having 1 to 12 carbon atoms including hetero atoms. Further, the hetero atom as used herein represents N, S, O, a halogen atom, or Se. In the groups shown below, Xa⁻ has the same definition as Za⁻ as described below, and Ra represents a substituent selected from the group consisting of a hydrogen atom, an alkyl group, an aryl group, a substituted or unsubstituted amino group, and a halogen atom.

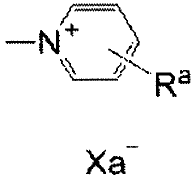

Each of R¹ and R² independently represents a hydrocarbon group having from 1 to 12 carbon atoms. In view of the storage stability of a recording layer coating liquid, each of R¹ and R² is preferably independently a hydrocarbon group having 2 or more carbon atoms, and it is particularly preferable that R¹ and R² are bonded to each other to form a 5-membered ring or a 6-membered ring.

Ar¹ and Ar² may be the same as or different from each other, and each of Ar¹ and Ar² represents an aryl group that may have a substituent. Preferable examples of the aryl group include a benzene ring and a naphthalene ring. Preferable examples of the substituent include a hydrocarbon group having 12 or fewer carbon atoms, a halogen atom, and an alkoxy group having 12 or fewer carbon atoms. Y¹ and Y² may be the same as or different from each other, and each of Y¹ and Y² represents a sulfur atom or a dialkylmethylene group having 12 or fewer carbon atoms. R³ and R⁴ may be the same as or different from each other, and each of R³ and R⁴ represents a hydrocarbon group having 20 or fewer carbon atoms that may have a substituent. Preferable examples of the substituent include an alkoxy group having 12 or fewer carbon atoms, a carboxy group, and a sulfo group. R⁵, R⁶, R⁷ and R⁸ may be the same as or different from each other, and each of R⁵, R⁶, R⁷ and R⁸ represents a hydrogen atom or a hydrocarbon group having 12 or fewer carbon atoms. In view of availability of the raw material, each of R⁵, R⁶, R⁷ and R⁸ preferably represents a hydrogen atom. Za⁻represents a counter anion. However, when the cyanine dye represented by Formula (e) has an anionic substituent in its structure and neutralization of charge is not necessary, Za⁻ may be omitted. In view of the storage stability of a recording layer coating liquid, preferable examples of the counter ion represented by Za⁻ include a halogen ion, a perchlorate ion, a tetrafluoroborate ion, a hexafluorophosphate ion, and a sulfonate ion, and particularly preferable examples include a perchlorate ion, a hexafluorophosphate ion, and an arylsulfonate ion.

More preferred examples of the infrared absorbing dye in the invention include a cyanine dye represented by the following Formula (e-2).

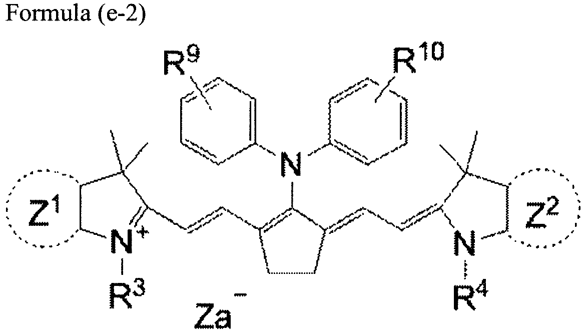

In the formula, each of Z¹ and Z² independently represents an aromatic ring or a heterocyclic aromatic ring which may have a substituent. Preferred examples of the aromatic ring include a benzene ring and a naphthalene ring. Further, preferred examples of the substituent include a hydrocarbon group having 12 or less carbon atoms, a halogen atom, and an alkoxy group having 12 or less carbon atoms, and most preferred examples thereof include a hydrocarbon group having 12 or less carbon atoms and an alkoxy group having 12 or less carbon atoms.

Each of R³ and R⁴ independently represents a hydrocarbon group having 20 or less carbon atoms which may have a substituent. Preferred examples of the substituent include an alkoxy group having 12 or less carbon atoms, a carboxy group, and a sulfo group.

Each of R⁹ and R¹⁰ independently represents a hydrogen atom or an alkoxy group that may have a substituent. Za⁻ represents a counter anion that is present in the case where neutralization of charges is required. From the standpoint of the storage stability of the image recording layer coating liquid, Za⁻ is preferably a halide ion, a perchloric acid ion, a tetrafluoroborate ion, a hexafluorophosphate ion, or a sulfonate ion, and particularly preferably a perchlorate ion, a hexafluorophosphate ion, or an arylsulfonate ion.

Specific examples of the cyanine dye represented by Formula (e) that can be preferably used include the compounds described in paragraphs [0017] to [0019] of JP-A No. 2001-133969, the compounds described in paragraphs [0016] to [0021] of JP-ANo. 2002-023360, and the compounds described in paragraphs [0012] to [0037] of JP-A No. 2002-040638, preferable examples thereof include the compounds described in paragraphs [0034] to [0041] of JP-A No. 2002-278057 and the compounds described in paragraphs [0080] to [0086] of JP-A No. 2008-195018, and most preferable examples thereof include the compounds described in paragraphs [0035] to [0043] of JP-ANo. 2007-90850.

In addition, the compounds described in paragraphs [0008] and [0009] of JP-A No. H05-5005 and the compounds described in paragraphs [0022] to [0025] of JP-A No. 2001-222101 are also preferred.

Only one of these infrared absorbing dyes may be used or two or more thereof may be used in combination. An infrared absorbing pigment other than the infrared absorbing dyes may also be additionally used. As the pigment, the compounds described in [0072] to [0076] of JP-A No. 2008-195018 are preferred.

A content of the infrared absorbing dye in the image recording layer is preferably from 0.1% by mass to 10.0% by mass, and more preferably from 0.5% by mass to 5.0% by mass, with respect to the total solid content of the image recording layer.

### [(b) Radical Generator]

The (b) radical generator is a compound that initiates and/or promotes the polymerization of the (c) polymerizable compound. As the radical generator, a known thermal polymerization initiator, a compound having a bond that has low bond dissociation energy, a photopolymerization initiator, or the like can be used.

Examples of the radical generator include (1) an organic halide, (2) a carbonyl compound, (3) an azo compound, (4) an organic peroxide, (5) a metallocene compound, (6) an azide compound, (7) a hexaaryl biimidazole compound, (8) an organic borate compound, (9) a disulfone compound, (10) an oxime ester compound, and (11) an onium salt compound.

As the (1) organic halide, the compounds described in paragraphs [0022] and [0023] of JP-A No. 2008-195018 are preferred.

As the (2) carbonyl compound, the compounds described in paragraph [0024] of JP-A No. 2008-195018 are preferred.

As the (3) azo compound, for example, the azo compounds described in JP-A No. H08-108621, or the like can be used.

As the (4) organic peroxide, for example, the compounds described in paragraph [0025] of JP-A No. 2008-195018 are preferred.

As the (5) metallocene compound, for example, the compounds described in paragraph [0026] of JP-A No. 2008-195018 are preferred.

Examples of the (6) azide compound include compounds such as 2,6-bis(4-azidobenzylidene)-4-methylcyclohexanone.

As the (7) hexaaryl biimidazole compound, for example, the compounds described in paragraph [0027] of JP-A No. 2008-195018 are preferred.

As the (8) organic borate compound, for example, the compounds described in paragraph [0028] of JP-A No. 2008-195018 are preferred.

Examples of the (9) disulfone compound include the compounds described in JP-A Nos. S61-166544 and 2002-328465.

As the (10) oxime ester compound, for example, the compounds described in paragraphs [0028] to [0030] of JP-A No. 2008-195018 are preferred.

Examples of the (11) onium salt compounds include onium salts such as: the diazonium salts described in S. I. Schlesinger, Photogr. Sci. Eng., 18, 387 (1974), and T. S. Bal et al., Polymer, 21, 423 (1980); the ammonium salts described in U.S. Pat. Nos. 4,069,055, JP-A No. H04-365049, and the like; the phosphonium salts described in U.S. Pat. Nos. 4,069,055 and 4,069,056; the iodonium salts described in European Patent No. 104,143, U.S. Patent Application No. 2008/0311520, and JP-A Nos. H02-150848 and 2008-195018; the sulfonium salts described in European Patent Nos. 370,693, 390,214, 233,567, 297,443, and 297,442, U.S. Pat. Nos. 4,933,377, 4,760,013, 4,734,444, and 2,833,827, and German Patent Nos. 2,904,626, 3,604,580, and 3,604,581; the selenonium salts described in J. V. Crivello et al., Macromolecules, 10 (6), 1307 (1977), and J. V. Crivello et al., J. Polymer Sci., Polymer Chem., Ed., 17, 1047 (1979); the arsonium salt described in C. S. Wen et al., Teh, Proc. Conf, Rad. Curing ASIA, p. 478, Tokyo, October (1988); and an azinium salt described in JP-A No. 2008-195018.

Among these, more preferable examples include the (11) onium salts, and in particular, an iodonium salt, a sulfonium salt, an azinium salt, and the (7) hexaaryl biimidazole compound. Specific examples of these compounds will be shown below, but the scope of the invention is not limited thereto.

Preferred examples of the iodonium salt include a diphenyliodonium salt; more preferred examples thereof include a diphenyliodonium salt substituted by an electron donating group, such as an alkyl group, or an alkoxyl group; and still more preferred examples thereof include an unsymmetrical diphenyliodonium salt. Specific examples thereof include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate, and bis(4-t-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, and tris(4-chlorophenyl)sulfonium 3,5-bis(methoxycarbonyl)benzenesulfonate.

Examples of the azinium salt include 1-cyclohexylmethyloxypyridinium hexafluorophosphate, 1-cyclohexyloxy-4-phenylpyridinium hexafluorophosphate, 1-methoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide, and 1-(2-ethylhexyloxy)-4-phenylpyridinium tetrafluoroborate.

Examples of the hexaarylbiimidazole compound include 2,2'-bis(o-chlorophenyl)-4,4',5,5'-tetraphenylbiimidazole, 2,2'-bis(o-bromophenyl)) 4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetrakis(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, and 2,2'-bis(o-trifluorophenyl)-4,4',5,5'-tetraphenylbiimidazole.

A content of the radical generator is preferably from 0.1% by mass to 50% by mass, more preferably from 0.5% by mass to 30% by mass, and particularly preferably from 0.8% by mass to 20% by mass, with respect to the total solid content of the image recording layer. Within this range, good sensitivity and good dirt resistance in the non-image area during printing may be obtained.

### [(c) Polymerizable Compound]

The polymerizable compound used in the image recording layer is an addition-polymerizable compound having at least one ethylenically unsaturated double bond, and is selected from compounds that have at least one ethylenically unsaturated bond, and is preferably selected from compounds that have two or more ethylenically unsaturated bonds. These compounds may have a chemical form of, for example, a monomer, a prepolymer (namely, a dimer, a trimer, or an oligomer), a mixture thereof, or a copolymer thereof.

Examples of the monomer include unsaturated carboxylic acids (for example, acrylic acid, methacrylic acid, itaconic acid, crotonic acid, isocrotonic acid, and maleic acid), and esters and amides thereof. Preferably, an ester of an unsaturated carboxylic acid and a polyhydric alcohol compound, or an amide of an unsaturated carboxylic acid and a polyvalent amine compound, is used. An addition reaction product between an unsaturated carboxylic acid ester or amide having a nucleophilic substituent such as a hydroxyl group, an amino group or a mercapto group and a monofunctional or polyfunctional isocyanate compound or epoxy compound, and a product of dehydration condensation reaction between the unsaturated carboxylic acid ester or amide and a monofunctional or polyfunctional carboxylic acid, are also suitable for use. A product of addition reaction between an unsaturated carboxylic acid ester or amide having an electrophilic substituent such as an isocyanate group or an epoxy group and a monofunctional or polyfunctional alcohol, amine or thiol, and a product of substitution reaction between an unsaturated carboxylic acid ester or amide having a leaving substituent such as a halogen group or a tosyloxy group and a monofunctional or polyfunctional alcohol, amine or thiol, are also favorable.

A class of compounds, each of which is obtained by replacing an unsaturated carboxylic acid in any of the polymerizable compounds described above with unsaturated phosphonic acid, styrene, vinyl ether, or the like, are also usable. These are described in reference documents including Japanese National Phase Publication (JP-A) No. 2006-508380, JP-A Nos. 2002-287344, 2008-25685, 2001-342222, H09-179296, H09-179297, H09-179298, 2004-294935, 2006-243493, H2002-275129, 2003-64130, 2003-280187, and H010-333321.

Among the polymerizable compounds, ethylene oxide-modified isocyanurate acrylates such as tris(acryloyloxyethyl)isocyanurate and bis(acryloyloxyethyl)hydroxyethylisocyanurate are particularly preferred from the viewpoint of an excellent balance between hydrophilicity, which relates to on-press developability, and polymerizability, which relates to print durability.

Details of the method to use these polymerizable compounds, such as the structures thereof, individual use or combined use thereof, and the addition amounts of thereof may be arbitrarily set according to performance design of a final planographic printing plate precursor. The polymerizable compound is used in an amount in a range of preferably 5% by mass to 75% by mass, more preferably 10% by mass to 70% by mass, and particularly preferably 15% by mass to 60% by mass, with respect to the total solid content of the image recording layer.

### [(d) Binder Polymer]

A binder polymer may be used in the image recording layer in order to improve the film strength of the image recording layer. Known binder polymers in the related art can be used as the binder polymer without limitation, and polymers having filming property are preferred. Among these, acrylic resins, polyvinyl acetal resins, and polyurethane resins are preferred.

Suitable examples of the binder polymers include those including a crosslinkable functional group in the main chain or the side chain for improving the film strength of the image area, and preferably in the side chain, as described in JP-A No. 2008-195018. Crosslink is formed between polymer molecules by the crosslinkable group to accelerate the curing.

As the crosslinkable functional group, ethylenically unsaturated groups such as a (meth)acrylic group, a vinyl group, an allyl group, and a styryl group, and an epoxy group are preferred, and these groups can be introduced into a polymer by a polymer reaction or copolymerization. For example, a reaction of an acrylic polymer or polyurethane having a carboxyl group in the side chain with glycidyl methacrylate, or a reaction of a polymer having an epoxy group with an ethylenically unsaturated group containing a carboxylic acid such as methacrylic acid can be used.

A content of the crosslinkable group in the binder polymer is preferably from 0.1 mmol to 10.0 mmol, more preferably from 0.25 mmol to 7.0 mmol, and most preferably from 0.5 mmol to 5.5 mmol, per gram of the binder polymer.

Preferably, the binder polymer further has a hydrophilic group. The hydrophilic group contributes to imparting on-press developability to the image recording layer,. Particularly, both print durability and developability can be attained by coexistence of the crosslinkable group and the hydrophilic group.

Examples of the hydrophilic group include a hydroxy group, a carboxy group, an alkylene oxide structure, an amino group, an ammonium group, an amide group, a sulfonic group, and a phosphate group, and among these, an alkylene oxide structure having 1 to 9 alkylene oxide units, each of which has 2 or 3 carbon atoms, is preferred. A monomer having the hydrophilic group may be subjected to copolymerization to impart the hydrophilic group to the binder polymer.

Moreover, a lipophilic group such as an alkyl group, an aryl group, an aralkyl group, or an alkenyl group can be introduced into the binder polymer in order to regulate the inking property. Specifically, a lipophilic group-containing monomer such as an alkyl ester methacrylate may be subjected to copolymerization.

Specific examples (1) to (11) of the binder polymer will be shown below, but the invention is not limited to these. The numerals attached to each repeating unit in the specific examples are each expressed in terms of a ratio of contents of the repeating units contained in the binder polymer in terms of mole.

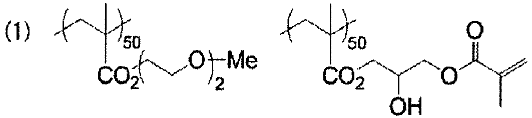

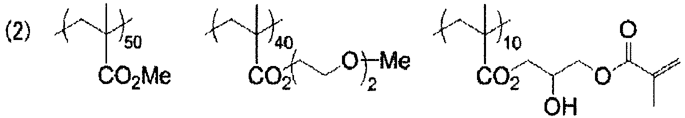

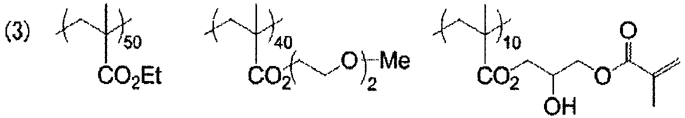

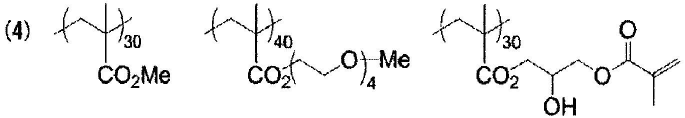

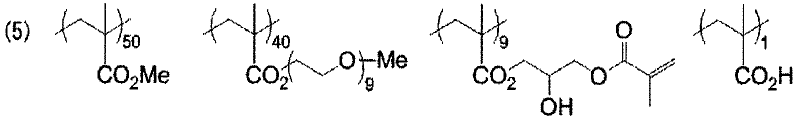

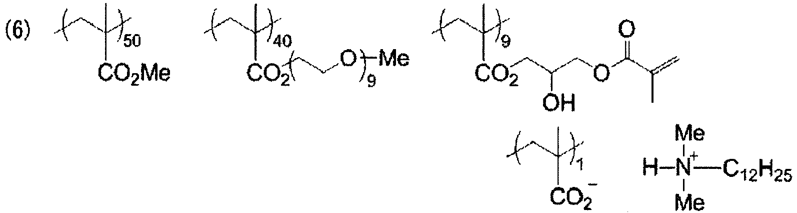

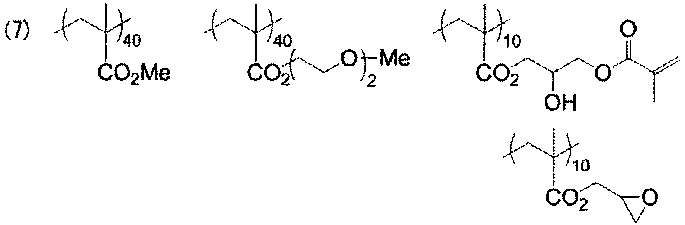

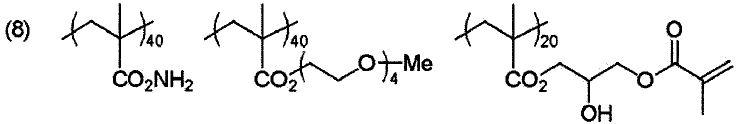

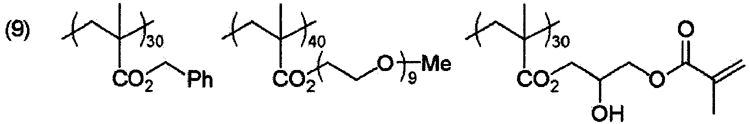

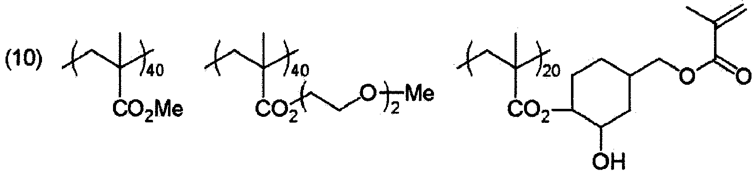

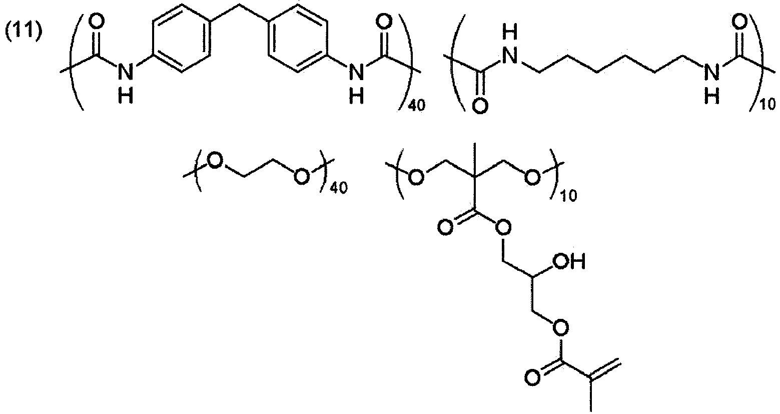

The binder polymer preferably has a mass-average molar weight (Mw) of from 2000 or more, more preferably 5000 or more, and still more preferably from 10,000 to 300,000.

### [Star Type Polymer]

The polymer compound for use in the invention is a star type polymer in which a main chain branches into three or more branches, and which is a polymer compound as represented by the following Formula (P-1).

Formula (P-1) A(̵Polymer)ₙ

In Formula (P-1), A represents a branch unit (constituent unit including branch points) of the star type polymer, and "Polymer" represents a partial structure having a polymer chain as a main chain and at least one selected from a polyethyleneoxy group or a polypropyleneoxy group as a side chain. n is 3 or more.

### [Polymer Moiety]

The star type polymer is a polymer compound that has the polymer chain as the main chain structure as described above, in which the polymer chain has at least one selected from a polyethyleneoxy group or a polypropyleneoxy group as a side chain.

The side chain may contain either a polyethyleneoxy group alone or a polypropyleneoxy group alone, or both of them.

The polyethyleneoxy group or the polypropyleneoxy group is a group represented by the following Formula (P-2).

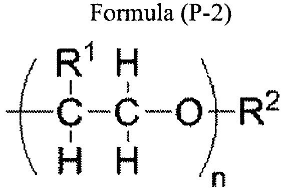

Here, R¹ represents a hydrogen atom or a methyl group, R² represents a hydrogen atom or an alkyl group having 1 to 12 carbon atoms, and n preferably represents 2 to 90, more preferably represents 2 to 50, still more preferably represents 2 to 12, and particularly preferably represents 2 to 8. Preferably, R¹ is a hydrogen atom, and R² is a hydrogen atom or a methyl group. n is more preferably 2 to 12, and particularly preferably 2 to 8.

In order to introduce the polyethyleneoxy group or the polypropyleneoxy group into the side chain of Polymer of Formula (P-1), a monomer of the following Formula (P-3) may be subjected to copolymerization.

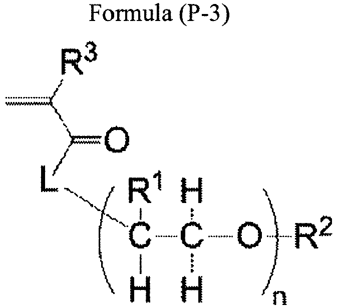

In Formula (P-3), R³ represents a methyl group or a hydrogen atom, and L represents an oxygen atom or NH. L is preferably an oxygen atom. R¹, R², and n have the same meanings as R¹, R², and n defined in Formula (P-2) respectively, and preferred examples thereof are also the same.

Specific examples of the monomer represented by Formula (P-3) are set forth below.

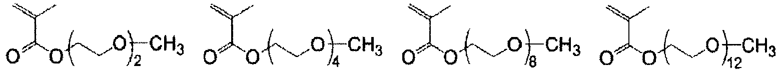

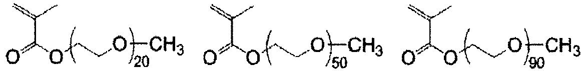

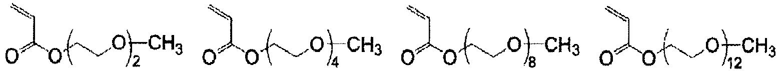

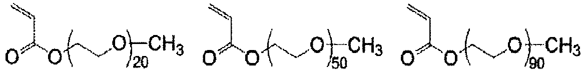

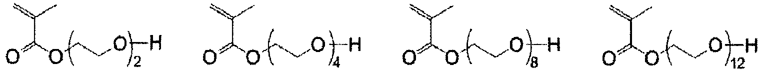

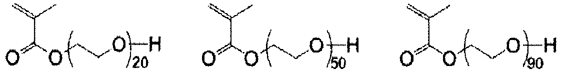

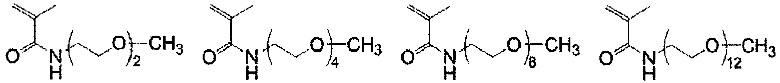

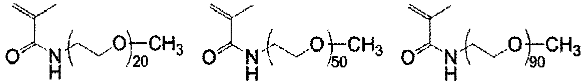

A content of the repeating unit derived from the monomer represented by Formula (3) is preferably from 20% by mass to 80% by mass, more preferably from 30% by mass to 70% by mass, and particularly preferably from 35% by mass to 65% by mass, in the polymer compound represented by Formula (1).

Moreover, in order to increase the film strength of the image area, the Polymer of Formula (P-1) preferably contains a repeating unit having an ethylenically unsaturated group. The ethylenically unsaturated group forms crosslinkage between the polymer molecules at the time of photopolymerization to accelerate photo-curing.

As the ethylenically unsaturated group, for example, a (meth)acryl group, a vinyl group, or an allyl group is preferred. The ethylenically unsaturated group can be introduced into the polymer by a polymer reaction or copolymerization. For example, a reaction between an acrylic polymer having a carboxyl group in its side chain and glycidyl methacrylate, a reaction between a polymer having an epoxy group and a carboxylic acid having an ethylenically unsaturated group, such as a methacrylic acid, or a reaction between a polymer having a hydroxy group and a methacrylate having an isocyanate group can be utilized.

From the standpoint of the storage stability of the polymer compound and the film strength, a (meth)acryl group is preferred.

Specific examples of the repeating unit having an ethylenically unsaturated group for use in the invention are set forth below, but the invention is not limited thereto.

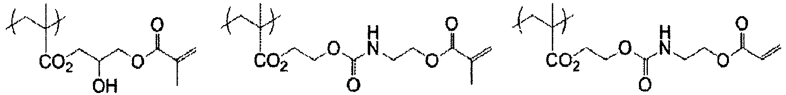

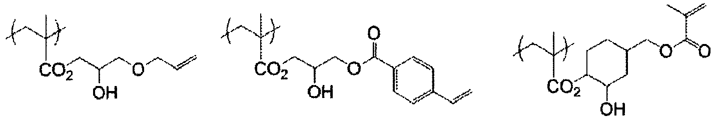

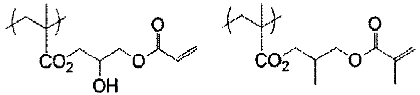

A content of the ethylenically unsaturated group in the polymer compound of the invention is preferably from 0.1 mmol to 10.0 mmol, more preferably from 0.25 mmol to 7.0 mmol, and most preferably from 0.5 mmol to 5.5 mmol, per gram of the polymer compound.

The star type polymer may contain another repeating unit. Specific examples of such a repeating unit will be described below, but the invention is not limited thereto.

(m1) Acrylic esters and methacrylic esters each having an aliphatic hydroxy group, such as 2-hydroxyethyl acrylate and 2-hydroxyethyl methacrylate.

(m2) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, and glycidyl acrylate.

(m3) Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, and glycidyl methacrylate.

(m4) Acrylamides and methacrylamides such as acrylamide, methacrylamide, N-methylolacrylamide, N-ethyl acrylamide, N-hexyl methacrylamide, N-cyclohexyl acrylamide, N-hydroxyethyl acrylamide, N-phenyl acrylamide, N-nitrophenyl acrylamide, and N-ethyl-N-phenyl acrylamide.

(m5) Vinyl ethers such as ethyl vinyl ether, 2-chloroethyl vinyl ether, hydroxyethyl vinyl ether, propyl vinyl ether, butyl vinyl ether, octyl vinyl ether, and phenyl vinyl ether.

(m6) Vinyl esters such as vinyl acetate, vinyl chloroacetate, vinyl butyrate, and vinyl benzoate.

(m7) Styrenes such as styrene, α-methylstyrene, methylstyrene, and chloromethylstyrene.

(m8) Vinyl ketones such as methyl vinyl ketone, ethyl vinyl ketone, propyl vinyl ketone, and phenyl vinyl ketone.

(m9) Olefins such as ethylene, propylene, isobutylene, butadiene, and isoprene.

(m10) N-vinylpyrrolidone, acrylonitrile, methacrylonitrile, and the like.

(m11) Unsaturated imides such as maleimide, N-acetyl methacrylamide, N-propionyl methacrylamide, and N-(p-chlorobenzoyl)methacrylamide.

Specific examples of the polymer chain represented by "Polymer" in Formula (P-1) are set forth below.

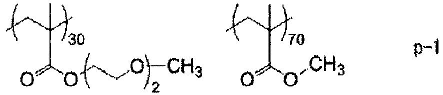

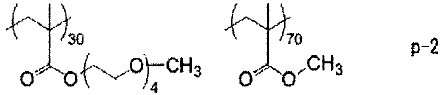

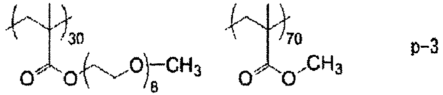

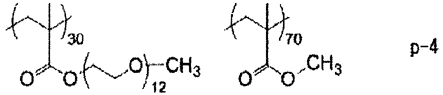

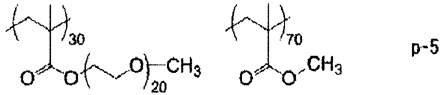

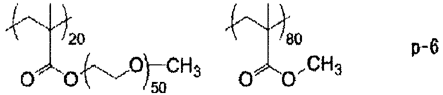

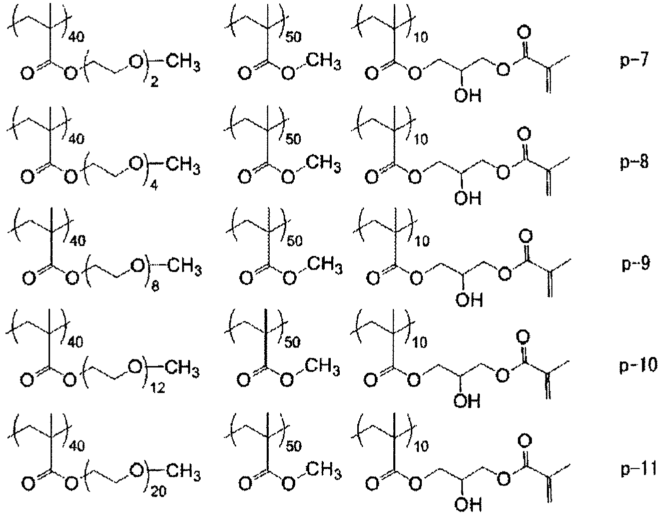

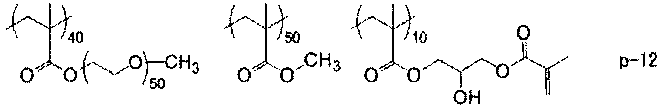

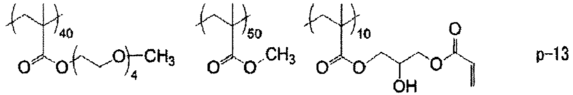

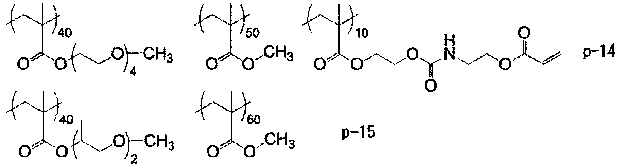

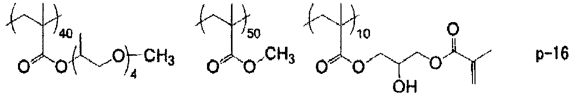

### [Branch Unit A]

The branch unit represented by A in Formula (P-1) is not particularly limited, but is preferably a branch unit having a hub portion, which is a residue of a thiol having three or more functional group. In an ideal structure, a main chain of an addition polymer extends from each thio moiety in the hub and thus, three or more main chains extend from the thio moieties. That is, the branch unit A preferably has a structure represented by the following Formula (P-4).

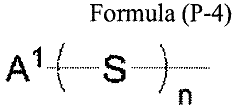

Here, A¹ represents a tri- or higher- valent organic group, and n represents an integer of 3 or more. Specific examples of A¹ include the following structures and organic groups composed of a combination of two or more of these structures. n is preferably an integer from 3 to 6, and particularly preferably an integer from 4 to 6.

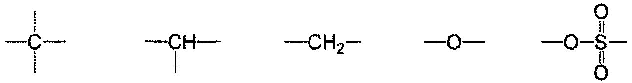

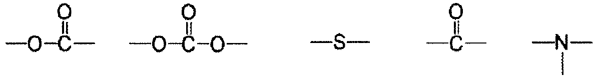

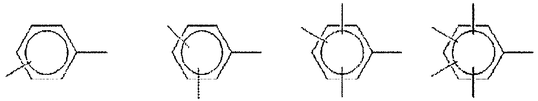

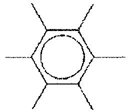

### Polyvalent naphthalene, Polyvalent anthracene

The thiol residue having three or more functional group is derived from an aromatic thiol or an aliphatic thiol. Examples of the aromatic thiol include benzene-1,3,5-trithiol, 3,4,8,9-tetramercaptotetrathiafulvalene, and 7-methyltrithiouric acid.

The thiol residue of the aliphatic thiol is preferably a residue of an ester formed from an alcohol having three or more functional group and a mercaptoalkanoic acid having 2 to 6 carbon atoms.

Examples of the alcohol suitable therefor include glycerine, sorbitol, an alcohol represented by Formula (P-5), and an alcohol having a group represented by Formula (P-6). In particular, the alcohol represented by Formula (P-5) and the alcohol having a group represented by Formula (P-6) are preferred.

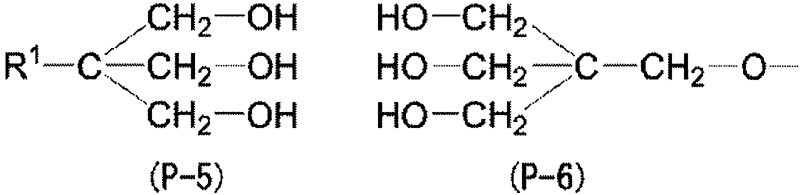

In the Formulae above, R¹ represents a hydrogen atom, an alkyl group having 1 to 4 carbon atoms, or a hydroxy-substituted alkyl group having 1 to 4 carbon atoms. In particular, a methyl group, an ethyl group, a hydroxymethyl group, and a hydroxyethyl group are preferred.

Examples of the mercaptoalkanoic acid having 2 to 6 carbon atoms include 2-mercaptoacetic acid, 2-mercaptopropionic acid, 3-mercaptopropionic acid, 4-mercaptobutyric acid, 5-mercaptovaleric acid, and 6-mercaptocaproic acid. Among these, 2-mercaptoacetic acid and 3-mercaptopropionic acid are preferred.

Specific examples of the ester formed from an alcohol having three or more functional group and a mercaptoalkanoic acid having 2 to 6 carbon atoms include a compound having three mercapto groups such as 1,2,6-hexanetrioltrithioglycolate, 1,3,5-trithiocyanuric acid, 1,3,5-tris(3-mercaptobutyryloxyethyl)-1,3,5-triazine-2,4,6(1H,3H,5H)-trione, trimethylolpropane tris(3-mercaptopropionate), trimethylolpropane tristhioglycolate, trimethylolpropane tristhiopropionate, trihydroxyethyltriisocyanuric acid tristhiopropionate, or tris-[(ethyl-3-mercaptopropionyloxy)-ethyl] isocyanurate; and a compound having four mercapto groups such as pentaerythritol tetrakis(3-mercaptopropionate), pentaerythritol tetrakis(3-mercaptobutyrate), pentaerythritol tetrakisthioglycolate, or dipentaerythritol hexakis-3-mercaptopropionate, but the invention is not limited thereto.

Commercially-available products of the multifunctional thiol compound include trimethylolpropane tristhiopropionate (TMTG) and pentaerythritol tetrakisthiopropionate (PETG) (both trademarks, manufactured by Yodo Kagaku Co., Ltd.), pentaerythritol tetrakis(3-mercaptobutyrate) (KARENZMT PE1)) and 1,3,5-tris(3-mercaptobutyloxyethyl)-1,3,5-triazine-2,4,6(1H,3H,5H)-trione (KARENZ MT NR1) (both trademarks, manufactured by Showa Denko K. K.), and trimethylolpropane tris-3-mercaptopropionate (TMMP), pentaerythritol tetrakis-3-mercaptopropionate (PEMP), dipentaerythritol hexakis-3-mercaptopropionate (DPMP), and tris-[(ethyl-3-mercaptopropionyloxy)-ethyl] isocyanurate (TEMPIC) (all trademarks, manufactured by Sakai Chemical Industry Co., Ltd.), but the multifunctional thiol compound of the invention is not limited thereto.

Examples of the branch unit represented by Formula (P-1) include those having the following structures.

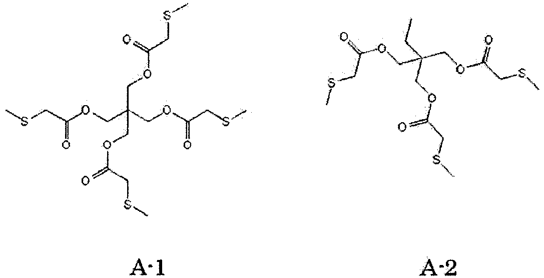

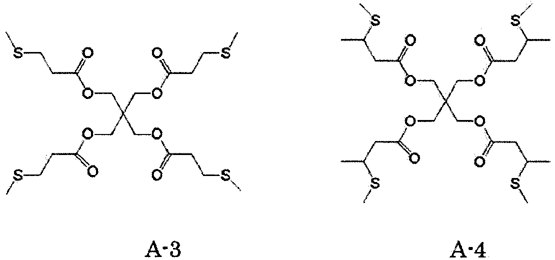

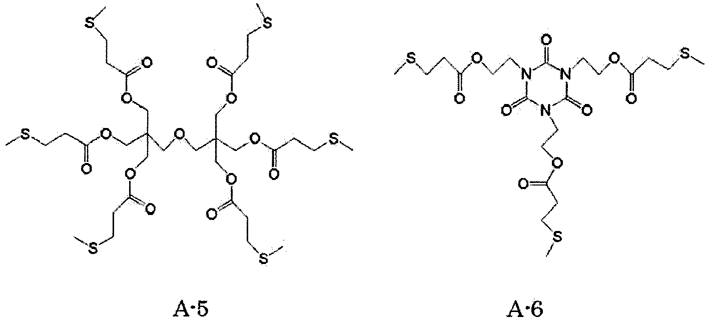

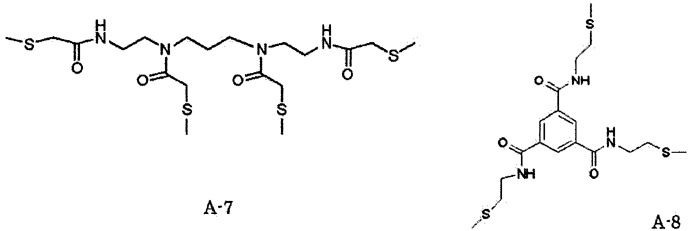

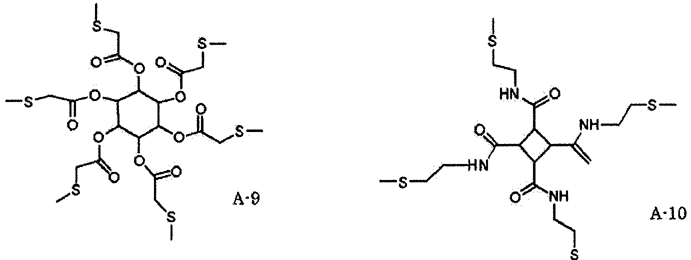

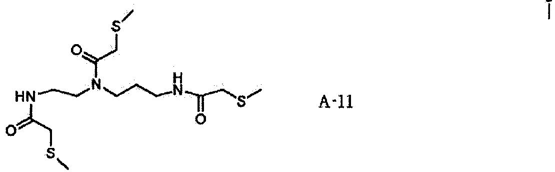

A weight-average molecular weight (Mw) of the star type polymer is preferably from 5,000 to 500,000, and more preferably from 10,000 to 250,000.

Specific examples of the star type polymer are shown in the following Table 1, together with the weight average molecular weight, by way of indicating the type of the branch unit and the polymer chain binding at terminals. However, the star type polymer for use in the invention is not limited thereto.

**[Table 1]**

| Star type polymer | Branch unit | Polymer chain | Mw |
|---|---|---|---|
| P-1 | A-1 | p-1 | 35,000 |
| P-2 | A-2 | p-1 | 27,000 |
| P-3 | A-3 | p-1 | 36,000 |
| P-4 | A-4 | p-1 | 36,000 |
| P-5 | A-5 | p-1 | 52,000 |
| P-6 | A-6 | p-1 | 27,000 |
| P-7 | A-7 | p-1 | 31,000 |
| P-8 | A-8 | p-1 | 31,000 |
| P-9 | A-9 | p-1 | 55,000 |
| P-10 | A-10 | p-1 | 35,000 |
| P-11 | A-1 | p-7 | 46,000 |
| P-12 | A-2 | p-7 | 38,000 |
| P-13 | A-3 | p-7 | 46,000 |
| P-14 | A-4 | p-7 | 45,000 |
| P-15 | A-5 | p-7 | 63,000 |
| P-16 | A-6 | p-7 | 38,000 |
| P-17 | A-7 | p-7 | 40,000 |
| P-18 | A-8 | p-7 | 41,000 |
| P-19 | A-9 | p-7 | 66,000 |
| P-20 | A-10 | p-7 | 46,000 |
| P-21 | A-1 | p-2 | 35,000 |
| P-22 | A-1 | p-3 | 36,000 |
| P-23 | A-1 | p-4 | 37,000 |
| P-24 | A-1 | p-5 | 38,000 |
| P-25 | A-1 | p-6 | 43,000 |
| P-26 | A-1 | p-8 | 46,000 |
| P-27 | A-1 | p-9 | 47,000 |
| P-28 | A-1 | p-10 | 48,000 |
| P-29 | A-1 | p-11 | 49,000 |
| P-30 | A-1 | p-13 | 46,000 |
| P-31 | A-1 | p-14 | 47,000 |
| P-32 | A-1 | p-15 | 36,000 |
| P-33 | A-1 | p-16 | 46,000 |

Only one kind of the star type polymers or a combination of two or more kinds thereof may be contained in the image recording layer. A content of the star type polymer in the image recording layer is preferably from 0.5% by mass to 90% by mass, more preferably from 1% by mass to 80% by mass, and still more preferably from 1.5% by mass to 70% by mass, with respect to the total solid content of the image recording layer.

The star type polymer can be synthesized by a known method such as radical polymerization of a monomer for forming the polymer chain in a presence of the multifunctional thiol compound.

### [(g) Polymer Fine Particles]

Polymer fine particles may be contained in the image recording layer in order to increase developability. In particular, the polymer fine particles are preferably fine particles of a polymer having a polyalkylene oxide structure. Among these, fine particles of a polymer having a polyalkylene oxide group in the side chain are preferred.

When the image recording layer contains fine particles of a polymer having a polyalkylene oxide structure, the peameability with respect to a dampening solution is improved, thereby providing better developability. As the polyalkylene oxide structure, an alkylene oxide structure having 2 to 120 alkylene oxide units, each of which having 2 or 3 carbon atoms, is preferred, and a polyethylene oxide structure having 2 to 120 ethylene oxide units is more preferred. In particular, a polyethylene oxide structure having 20 to 100 ethylene oxide units is preferred. By the fine particles of a polymer having such a polyalkylene oxide structure, both the printing durability and the developability can be obtained. Further, the inking property can be improved.

The polymer fine particles are preferably hydrophobic precursors that can convert the image recording layer to a hydrophobic one when heat is applied thereto. As the hydrophobic precursor-polymer fine particles, at least one selected from the group consisting of hydrophobic, thermoplastic polymer fine particles, thermally reactive polymer fine particles, a microcapsule that encapsulates at least a part of constituent components of the image recording layer, and micro gels (fine particles of a crosslinked polymer) is preferred. Among these, fine particles of a polymer having a polymerizable group and micro gels are preferred. In order to improve the developability, it is preferable that a polyalkylene oxide structure is included therein as described above.

Preferable examples of the hydrophobic, thermoplastic polymer fine particles include hydrophobic thermoplastic polymer fine particles described in Research Disclosure No. 333003, January, 1992, JP-A Nos. H09-123387, H09-131850, H09-171249, and H09-171250, European Patent No. 931647, and the like.

Specific examples of the polymer that forms the polymer fine particles include: a homopolymer and a copolymer of monomers such as ethylene, styrene, vinyl chloride, methyl acrylate, ethyl acrylate, methyl methacrylate, ethyl methacrylate, vinylidene chloride, acrylonitrile, vinylcarbazole, and acrylates and methacrylates having a polyalkylene structure; and a mixture thereof. Among these, more suitable examples thereof include copolymers containing polystyrene, styrene, and acrylonitrile, and polymethyl methacrylates.

An average particle diameter of the hydrophobic thermoplastic polymer fine particles is preferably from 0.01 µm to 2.0 µm.

Examples of the thermally reactive polymer fine particles include fine particles of a polymer having a thermally reactive group. These form a hydrophobic region by crosslinking due to a thermal reaction and a subsequent change in functional groups.

The thermally reactive group in the fine particles of a polymer having a thermally reactive group may be any functional group that undergoes any reaction, as long as a chemical bond is formed thereby. Preferable examples of the thermally reactive group include ethylenically unsaturated groups that undergo a radical polymerization reaction (for example, an acryloyl group, a methacryloyl group, a vinyl group, and an allyl group); cationic polymerizable groups (for example, a vinyl group and a vinyloxy group); an isocyanate group that undergoes an addition reaction and a block copolymer thereof; an epoxy group, a vinyloxy group, and functional groups having an active hydrogen atom reactive with the epoxy group and the vinyloxy group (for example, an amino group, a hydroxy group, and a carboxy group); a carboxyl group that undergoes a condensation reaction and a hydroxy group and an amino group that are reactive with the carboxy group; and acid anhydrides that undergo a ring opening addition reaction, and an amino group and an hydroxy group that are reactive with the acid anhydrides.

Examples of the microcapsule include those which encapsulate all or part of the constituent components of the image recording layer in the microcapsule, as described in JP-A Nos. 2001-277740 and 2001-277742, and EP No. 2383118. Further, the constituent components of the image recording layer may also be contained outside of the microcapsule. In addition, in a preferred aspect, the image recording layer containing the microcapsule encapsulates a hydrophobic constituent component in the microcapsule, and contains a hydrophilic constituent component outside of the microcapsule.

The image recording layer may have crosslinking resin particles, that is, a micro gel. The micro gel can contain a part of the constituent components of the image recording layer within the micro gel and/or on the surface of the micro gel. An aspect of a reactive micro gel obtained by including the (c) polymerizable compound on the surface of the micro gel is particularly preferable from the viewpoint of image formation sensitivity and print durability.

As a method for microencapsulating or microgelling the constituent components of the image recording layer, known methods can be applied.

An average particle diameter of the microcapsule and that of the micro gel are preferably from 0.01 µm to 3.0 µm, more preferably from 0.05 µm to 2.0 µm, and particularly preferably from 0.10 µm to 1.0 µm. Good resolution and stability over time are obtained at an average particle diameter in this range.

A content of the polymer fine particles is preferably in a range from 5% by mass to 90% by mass with respect to the total solid of the image recording layer.

### [Other Components]

The image recording layer can further contain the following components, if necessary.

### (1) Hydrophilic, low-molecular-Weight Compound

The image recording layer may contain a hydrophilic, low-molecular-weight compound in order to improve on-press developability without causing deterioration of print durability.

Examples of the hydrophilic, low-molecular compound include, as a water-soluble organic compound: glycols such as ethylene glycol, diethylene glycol, triethylene glycol, propylene glycol, dipropylene glycol, and tripropylene glycol, and ethers and ester derivatives thereof; polyols such as glycerine, pentaerythritol, and tris(2-hydroxyethyl)isocyanurate; organic amines such as triethanolamine, diethanolamine, and monoethanolamine, and salts thereof; organic sulfonic acids such as alkylsulfonic acid, toluenesulfonic acid, and benzenesulfonic acid, and salts thereof; organic sulfamic acids such as alkylsulfamic acid, and salts thereof; organic sulfuric acids such as alkylsulfuric acid and alkylethersulfuric acid, and salts thereof; organic phosphonic acids such as phenylphosphonic acid, and salts thereof; organic carboxylic acids such as tartaric acid, oxalic acid, citric acid, malic acid, lactic acid, gluconic acid, and amino acids, and salts thereof; and betaines.

Among these, at least one selected from the group consisting of polyols, organic sulfates, organic sulfonates, and betaines is preferably contained in the image recording layer.

Specific examples of a compound that is among the organic sulfonates include: alkylsulfonates such as sodium n-butylsulfonate, sodium n-hexylsulfonate, sodium 2-ethylhexylsulfonate, sodium cyclohexylsulfonate, and sodium n-octylsulfonate; alkylsulfonates containing an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, and sodium 5,8,11,14-tetraoxatetradecosane-1-sulfonate; arylsulfonates such as sodium benzenesulfonate, sodium p-toluenesulfonate, sodium p-hydroxybenzenesulfonate, sodium p-styrenesulfonate, sodium dimethyl-5-sulfonatoisophthalate, sodium 1-naphthylsulfonate, sodium 4-hydroxynaphthylsulfonate, disodium 1,5-naphthalenedisulfonate, and trisodium 1,3,6-naphthalenetrisulfonate; and the compounds described in paragraphs [0026] to [0031] of JP-A No. 2007-276454, and paragraphs [0020] to [0047] of JP-A No. 2009-154525. The salts may be either a potassium salt or a lithium salt.

Examples of the organic sulfate include a sulfate of an alkyl ether of polyethylene oxide, a sulfate of an alkenyl ether of polyethylene oxide, a sulfate of an alkynyl ether of polyethylene oxide, a sulfate of an aryl ether of polyethylene oxide, and a sulfate of a heterocyclic monoether of polyethylene oxide. Here, a number of ethylene oxide units contained in the polyethylene oxide is preferably from 1 to 4, and the sulfate is preferably a sodium salt, a potassium salt, or a lithium salt. Specific examples thereof include the compounds described in paragraphs [0034] to [0038] of JP-A No. 2007-276454.

As the betaine, a compound in which a number of carbon atoms contained in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-propanesulfonate, and 3-(1-pyridinio)-1-propanesulfonate.

The hydrophilic, low-molecular compound has almost no surface active function since a structure of a hydrophobic portion thereof is small, and accordingly, it may enable to prevent deterioration of the hydrophobicity and film strength of the image area due to penetration of the dampening solution into the exposed area (image area) of the image recording layer, so that the ink receptivity and printing durability of the image recording layer can be favorably maintained.

A content of the hydrophilic, low-molecular compound in the image recording layer is preferably from 0.5% by mass to 20% by mass, more preferably from 1 % by mass to 15% by mass, and still more preferably from 2% by mass to 10% by mass, with respect to the total amount of the solids of the image recording layer. Within this range, good on-press developability and good printing durability may be obtained.

These compounds may be contained individually or in combination of two or more kinds thereof.

### (2) Oil-Sensitizing Agent

In order to improve the inking property, the image recording layer may contain an oil-sensitizing agent such as a phosphonium compound, a nitrogen-containing, low-molecular compound, or an ammonium group-containing polymer. In particular, in a case in which a protective layer contains an inorganic laminar compound, the oil-sensitizing agent functions as a surface covering agent and prevents deterioration of the inking property during printing due to the inorganic laminar compound.

A content of the oil-sensitizing agent is preferably from 0.01 % by mass to 30.0% by mass, more preferably from 0.1% by mass to 15.0% by mass, and still more preferably from 1% by mass to 10% by mass, with respect to the total amount of the solids of the image recording layer.

### (3) Others

The image recording layer may contain a surfactant, a colorant, a print-out agent, a polymerization suppressor, an ultraviolet absorber, a higher fatty acid derivative, a plasticizer, fine inorganic particles, an inorganic laminar compound, a co-sensitizing adjuvant, a chain transfer agent, or the like as additional components. Specifically, the compounds and the addition amounts thereof described in paragraphs [0114] to [0159] of JP-A No. 2008-284817, paragraphs [0023] to [0027] of JP-A No. 2006-091479, and paragraph [0060] of U.S. Patent Publication No. 2008/0311520 are preferred.

### [Formation of Image Recording Layer]

The image recording layer is formed by, for example, dispersing or dissolving each of the necessary components described above in a known solvent to prepare a coating liquid, and coating the coating liquid on a support by a known method such as bar coater coating, following by drying, as described in paragraphs [0142] to [0143] of JP-A No. 2008-195018. A coating amount (solid content) of the image recording layer on a support, obtained after coating and drying, may vary according to the intended purpose, but is generally preferably from 0.3 g/m² to 3.0 g/m². Within this range, good sensitivity and good film characteristics of the image recording layer may be obtained.

### [Undercoat Layer]

The planographic printing plate precursor preferably has an undercoat layer (, which may be referred to as an intermediate layer,) provided between the image recording layer and the support. The undercoat layer strengthens adhesion between the support and the image recording layer in an exposed area and makes removal of the image recording layer from the support in the unexposed area easy, thereby contributing to improvement in the developing property without being accompanied by degradation of the printing durability. Further, in a case of subjecting the planographic printing plate precursor to infrared laser exposure, since the undercoat layer functions as a heat insulating layer, a decrease in sensitivity due to diffusion of heat generated upon the exposure into the support is prevented.

Examples of the compound for use in the undercoat layer include compounds having an acid group, such as phosphonic acid, phosphoric acid, and sulfonic acid. Examples thereof further include a compound having an adsorbing group capable of being adsorbed on a support surface and a compound having a crosslinkable group so as to improve adhesion to the image recording layer. These compounds may have a low molecular weight or may be a high-molecular polymer. Two or more kinds of these compounds may be used, if necessary.

If the compound for use in the undercoat layer is a high-molecular polymer, the high-molecular polymer is preferably a copolymer of a monomer having an adsorbing group, a monomer having a hydrophilic group, and a monomer having a crosslinkable group. As the adsorbing group capable of being adsorbed on a support surface, a phenolic hydroxy group, a carboxyl group, -PO₃H₂, -OPO₃H₂, -CONHSO₂-, -SO₂NHSO₂-, and -COCH₂COCH₃ are preferred. As the hydrophilic group, a sulfo group is preferred. As the crosslinkable group, a methacryl group, an allyl group, and the like are preferred. The high-molecular polymer may contain a crosslinkable group introduced by a salt formation between a polar substituent of the high-molecular polymer and a compound containing a substituent having a counter charge thereto and an ethylenically unsaturated bond, and also may further be copolymerized with a monomer which is different from those described above and which is preferably a hydrophilic monomer.

Specifically, preferable examples thereof include a silane coupling agent having an addition-polymerizable ethylenic double bond reactive group described in JP-A No. H10-282679 and a phosphorus compound having an ethylenic double bond reactive group described in JP-A No. H02-304441. Also preferred are those containing a low-molecular compound or a polymer compound having a crosslinkable group (preferably an ethylenically unsaturated bond group), a functional group capable of interacting with a support surface, and/or a hydrophilic group, described in each of JP-A Nos. 2005-238816, 2005-125749, 2006-239867, and 2006-215263. More preferred are those having an adsorbing group capable of being adsorbed on a support surface, a hydrophilic group, and a crosslinkable group, described in JP-A Nos. 2005-125749 and 2006-188038.

A content of the unsaturated double bonds in the high-molecular polymer for the undercoat layer is preferably from 0.1 mmol to 10.0 mmol, and more preferably from 0.2 mmol to 5.5 mmol, with respect to 1 g of the high-molecular polymer.

A mass average-molecular mass of the high-molecular polymer for the undercoat layer is preferably 5,000 or more, and more preferably from 10,000 to 300,000.

The undercoat layer according to the invention may contain a chelating agent, a secondary- or tertiary- amine, a polymerization suppressor, a compound containing an amino group or a functional group having a polymerization suppression ability, and a group capable of interacting with a surface of an aluminum support, or the like (for example, 1,4-diazobicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid, and hydroxyethyliminodiacetic acid), in addition to the compounds for the undercoat layer, in order to prevent getting dirt over time.

The undercoat layer is coated according to a known method. A coating amount (solid content) of the undercoat layer is preferably from 0.1 mg/m² to 100 mg/m², and more preferably from 1 mg/m² to 30 mg/m².

### [Support]

As the support for use in the photosensitive planographic printing plate precursor, a known support is used. Particularly, an aluminum plate that has been subjected to a roughening processing and an anodizing processing by a known method is preferred.

The aluminum plate may have been subjected to a process for enlarging or sealing of micropores of an anodized film such as one that described in JP-A No. 2001-253181 or 2001-322365 or a surface hydrophilizing process, for example, with an alkali metal silicate as described in U.S. Pat. Nos. 2,714,066, 3,181,461, 3,280,734, and 3,902,734 or polyvinyl phosphonic acid as described in U.S. Pat. Nos. 3,276,868,4,153,461, and 4,689,272, if necessary.

The support preferably has a center line average roughness of from 0.10 µm to 1.2 µm.

The support for use in the planographic printing plate precursor may have, on the back surface thereof, a backcoat layer containing an organic polymer compound described in JP-A No. H05-45885 or an alkoxy compound of silicon described in JP-A No. H06-35174, if necessary.

### [Protective Layer]

The planographic printing plate precursor preferably has a protective layer (overcoat layer) on the image recording layer. The protective layer functions to prevent generation of a scratch on the image recording layer and to prevent ablation during high-illuminance laser exposure, as well as to suppress a reaction which suppresses image forming by blocking oxygen.

Details of the protective layer having the characteristics above are described in, for example, U.S. Patent No. 3,458,311 and Japanese Patent Publication (JP-B) No. S55-49729. As a low oxygen-peameable polymer for use in the protective layer, any of a water-soluble polymer and a water-insoluble polymer may be suitably selected and used, and if necessary, a mixture of two or more kinds thereof can be used. Specific examples thereof include polyvinyl alcohol, modified polyvinyl alcohol, polyvinyl pyrrolidone, a water-soluble cellulose derivative, and poly(meth)acrylonitrile.

As the modified polyvinyl alcohol, an acid-modified polyvinyl alcohol having a carboxyl group or a sulfo group is preferably used. Specifically, the modified polyvinyl alcohols described in JP-A Nos. 2005-250216 and 2006-259137 are preferable.

The protective layer particularly preferably contains a hydrophilic polymer containing a repeating unit represented by the following Formula (1) and a repeating group represented by the following Formula (2), described in JP-A No. 2012-73597 (hereinafter also referred to as a specific hydrophilic polymer).

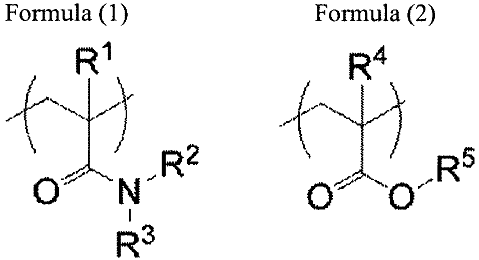

In Formulae (1) and (2), each of R¹ and R⁴ independently represents a hydrogen atom or a methyl group. Each of R² and R³ independently represents a hydrogen atom, a methyl group, or an ethyl group. R⁵ represents a linear-, branched-, or cyclic- unsubstituted alkyl group having 2 to 8 carbon atoms, a substituted alkyl group that may have an aromatic ring or a heterocycle as a substituent, or a substituent represented by the following Formula (3).

Further, examples of the substituent that may be introduced to the substituted alkyl group include an aromatic ring group, a heterocyclic group, and a polyether group.

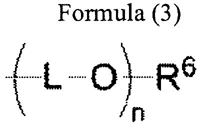

In Formula (3), L represents an alkylene group having 2 to 6 carbon atoms and R⁶ represents a linear, branched, or cyclic unsubstituted alkyl group having 4 to 8 carbon atoms or an aromatic substituted alkyl group. n represents an average addition molar number of the polyether and represents a number from 2 to 4.

In the repeating unit represented by Formula (1), both of R² and R³ are preferably hydrogen atoms. In the repeating unit represented by Formula (2), R⁵ is preferably a linear-, branched-, or cyclic-, unsubstituted alkyl group having 2 to 8 carbon atoms.

As a combination of the repeating units represented by the respective Formulae (1) and (2), a combination in which R¹ and R⁴ of Formulae (1) and (2) are each a hydrogen atom, R² and R³ of Formula (1) are each a hydrogen atom, and R⁵ of Formula (2) is a branched and unsubstituted alkyl group having 4 carbon atoms is most preferred.

It is preferable that the specific hydrophilic polymer further has a repeating unit represented by the following Formula (4).

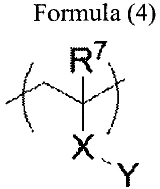

In Formula (4), R⁷ represents a hydrogen atom or a methyl group. X represents a single bond, a divalent linking group selected from structures shown in the following Structural Group (5), or a divalent linking group formed by a combination of plural structures selected from structures shown in the following Structural Group (6). Y represents a carboxylic acid group, a carboxylate salt group, a sulfonic acid group, a sulfonate salt group, a phosphoric acid group, a phosphate salt group, a phosphonic acid group, a phosphonate salt group, a hydroxyl group, a carboxybetaine group, a sulfobetaine group, an ammonium group, or a polyether group represented by the following Formula (7).

In the repeating unit represented by Formula (4), from the viewpoints of water solubility and on-press developability, Y is preferably a sulfonic acid group, a sulfonate salt group, a carboxybetaine group, a sulfobetaine group, or an ammonium group, and more preferably a sulfonic acid group, a sulfonate salt group, or a sulfobetaine group.

X is preferably a divalent linking group selected from structures shown in the following Structural Group (5), or a divalent linking group formed by a combination of plural structures selected from structures shown in the following Structural Group (6).

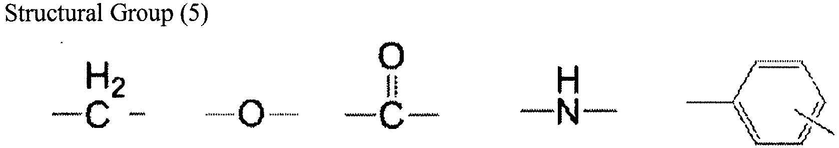

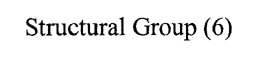

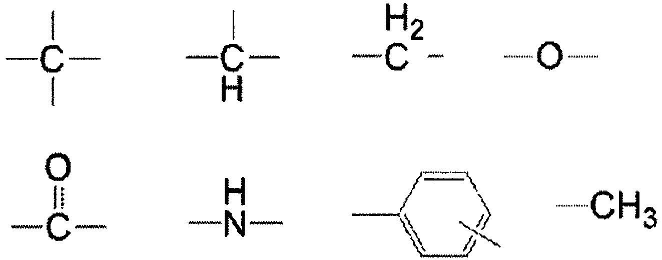

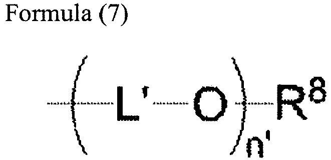

In Formula (7), L' represents an alkylene group having 2 or 3 carbon atoms and R⁸ represents a hydrogen atom or a methyl group. n' represents an average addition molar number of polyether and represents a number from 2 to 4.

Specific examples of a monomer from which the repeating unit represented by Formula (1) is derived include acrylamide, methacrylamide, N-methyl acrylamide, N-methyl methacrylamide, N-ethyl acrylamide, N-ethyl methacrylamide, N,N-dimethyl acrylamide, N,N-dimethyl methacrylamide, N,N-diethyl acrylamide, N,N-diethyl methacrylamide, N,N-ethylmethyl acrylamide, and N,N-ethylmethyl methacrylamide.

Specific examples of a monomer from which the repeating unit represented by Formula (2) is derived include methyl acrylate, ethyl acrylate, propyl acrylate, isopropyl acrylate, n-butyl acrylate, i-butyl acrylate, t-butyl acrylate, pentyl acrylate, hexyl acrylate, cyclohexyl acrylate, heptyl acrylate, octyl acrylate, 2-ethylhexyl acrylate, nonyl acrylate, decyl acrylate, 2-(2-ethylhexyloxyethoxy)ethyl acrylate, methyl methacrylate, ethyl methacrylate, propyl methacrylate, isopropyl methacrylate, n-butyl methacrylate, i-butyl methacrylate, t-butyl methacrylate, pentyl methacrylate, hexyl methacrylate, cyclohexyl methacrylate, heptyl methacrylate, octyl methacrylate, 2-ethylhexyl methacrylate, nonyl methacrylate, and decyl methacrylate.

A content of the repeating unit represented by Formula (1) in the specific hydrophilic polymer is preferably from 65% by mole to 96.7% by mole, more preferably from 70% by mole to 80% by mole, and particularly preferably from 74% by mole to 80% by mole. A content of the repeating unit represented by Formula (2) in the specific hydrophilic polymer is preferably from 3% by mole to 30% by mole, more preferably from 20% by mole to 30% by mole, and particularly preferably from 20% by mole to 26% by mole.

Specific examples of a monomer from which the repeating unit represented by Formula (4) is derived include 2-acryloylamino-2-methylpropanesulfonic acid, sodium 2-acryloylamino-2-methylpropanesulfonate, potassium 2-acryloylamino-2-methylpropanesulfonate, 4-((3-methacrylamidopropyl)dimethylammonio)butane-1-sulfonate, 4-((3-acrylamidopropyl)dimethylammonio)butane-1-sulfonate, vinyl alcohol, acrylic acid, methacrylic acid, sodium styrenesulfonate, diethylene glycol monomethyl ether methacrylate, hydroxyethyl acrylate, hydroxyethyl methacrylate, methacrylcholine chloride, potassium 3-sulfopropyl methacrylate, 2-(methacryloyloxy)ethyl phosphate, dimethyl-N-methacryloyloxyethyl-N-carboxymethyl-ammonium betaine, and vinylphosphonic acid.

The specific hydrophilic polymer preferably contains the repeating unit represented by Formula (4) at a content of from 0.3% by mole to 5% by mole, more preferably from 0.3% by mole to 3% by mole, and still more preferably from 0.3% by mole to 1.5% by mole.

If the specific hydrophilic polymer for use in the protective layer contains the repeating unit represented by Formula (4) in the preferred range, a good on-press developability, inking property, and printing durability may be provided to the photosensitive planographic printing plate precursor.

A weight-average molecular weight (Mw) of the specific hydrophilic polymer is preferably in a range of from 10,000 to 200,000, more preferably in a range of from 10,000 to 100,000, and most preferably in a range of from 10,000 to 30,000.

Specific examples of the specific hydrophilic polymer are set forth below. The ratio x, y, and z (composition ratio, in terms of % by mole) of the respective repeating units and Mw of the specific hydrophilic polymer are shown in Table 2.

A content of the specific hydrophilic polymer in the protective layer is preferably 40% by mass or more, more preferably 60% by mass or more, and particularly preferably 80% by mass or more, with respect to the solid content of the protective layer. In this range, a planographic printing plate having a better inking property and higher printing durability may be provided, and a planographic printing plate precursor having excellent on-press developability may be obtained.

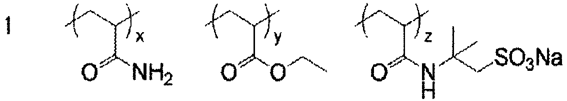

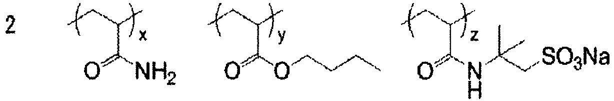

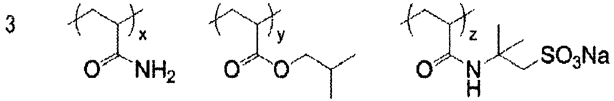

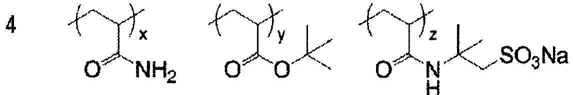

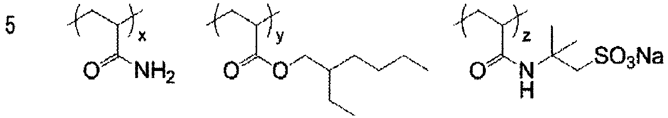

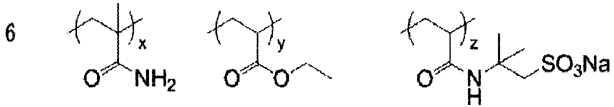

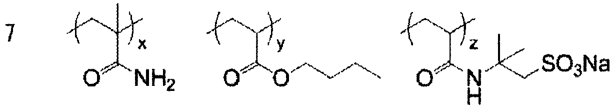

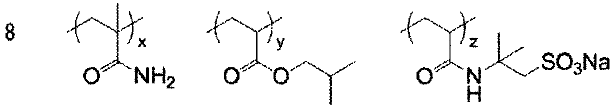

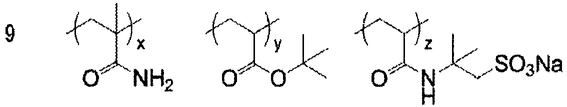

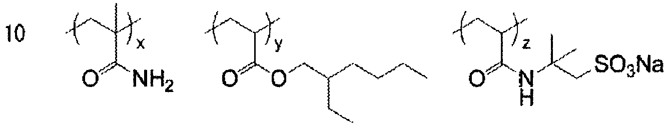

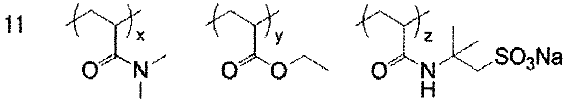

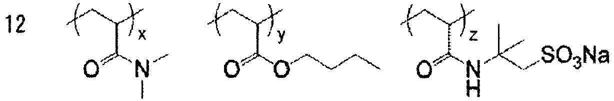

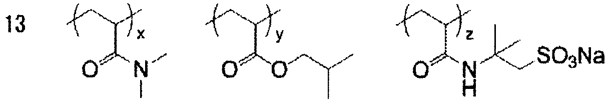

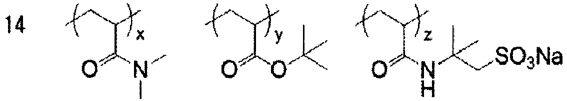

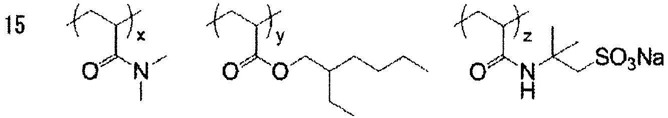

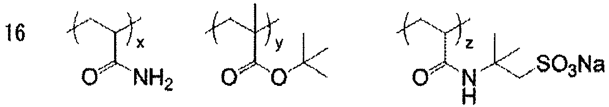

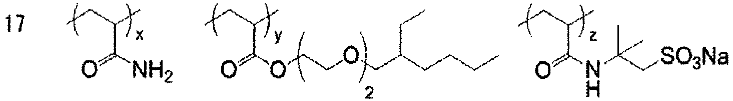

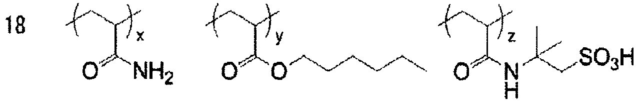

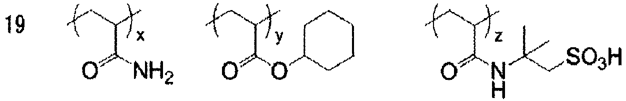

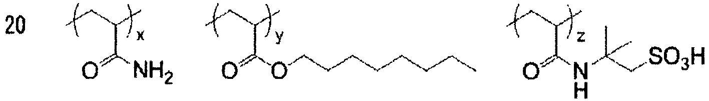

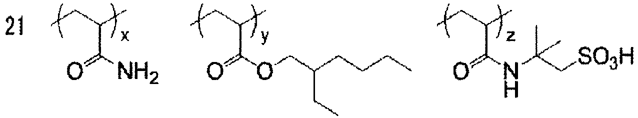

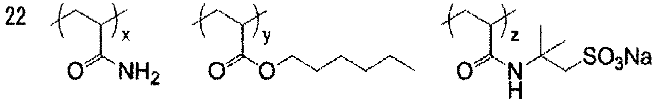

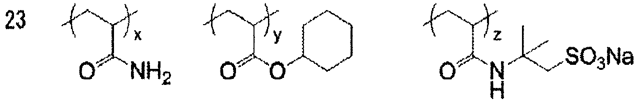

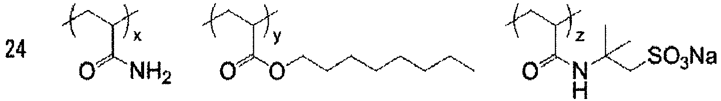

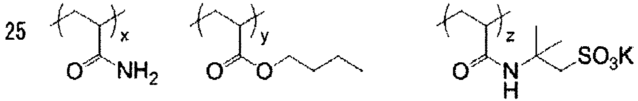

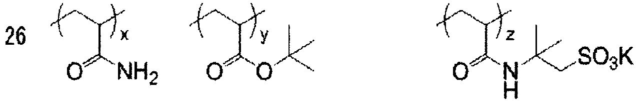

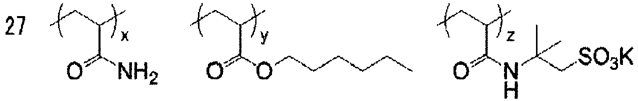

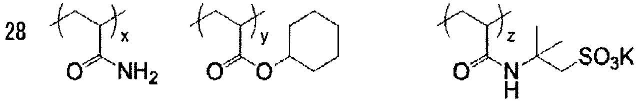

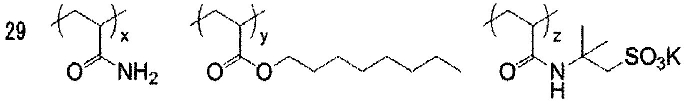

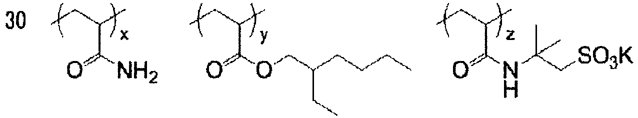

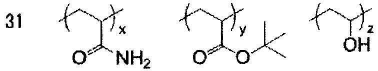

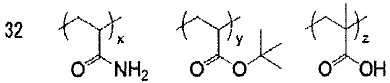

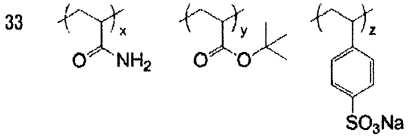

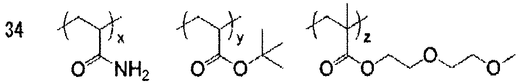

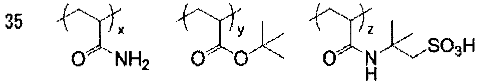

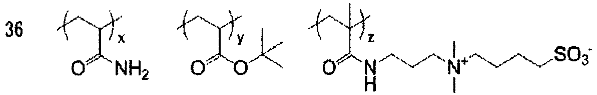

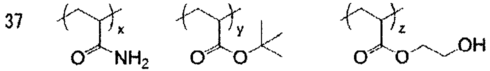

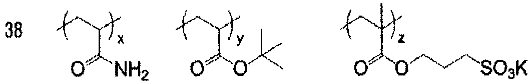

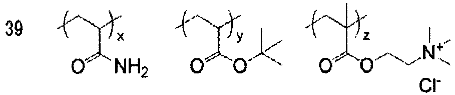

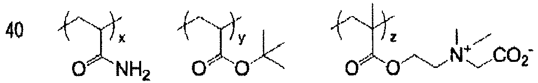

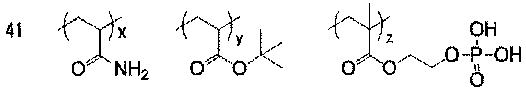

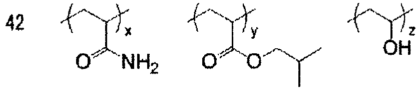

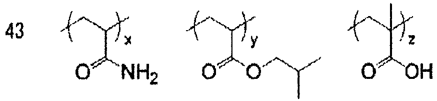

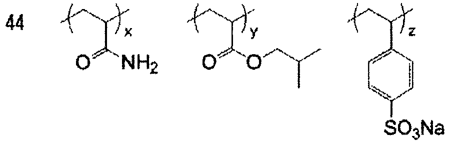

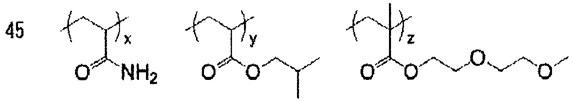

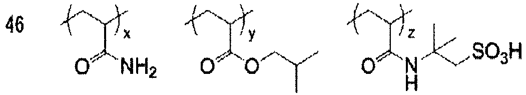

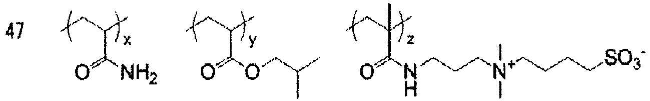

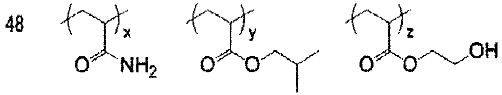

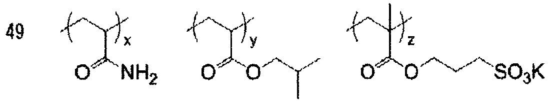

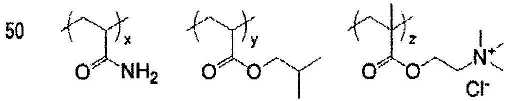

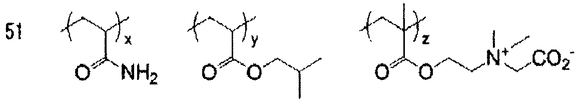

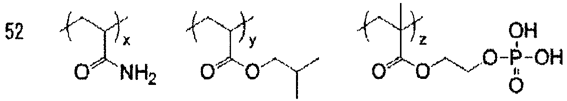

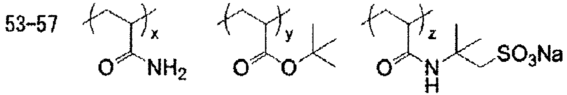

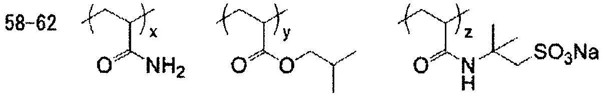

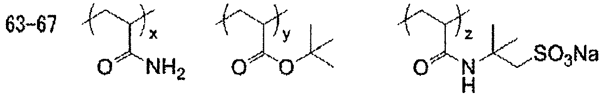

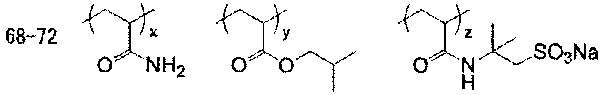

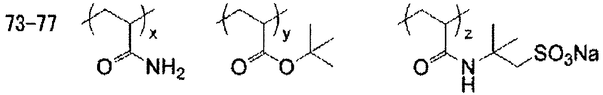

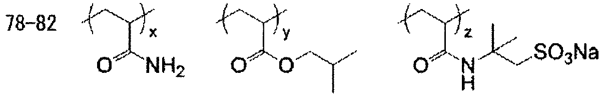

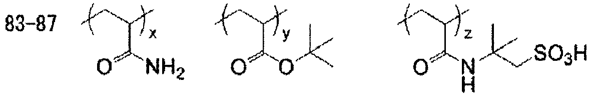

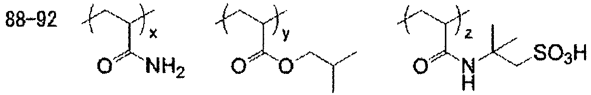

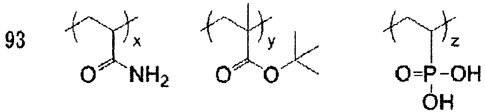

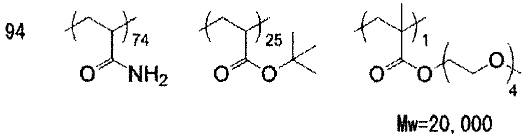

**[Table 2]**

| Hydrophilic polymer (e) Compound No. | Composition ratio (% by mole) | | | Mw |
|---|---|---|---|---|
| | x | y | z | |
| 1 to 52 | 74 | 25 | 1 | 20000 |
| 53 | 94 | 5 | 1 | 20000 |
| 54 | 89 | 10 | 1 | 20000 |
| 55 | 84 | 15 | 1 | 20000 |
| 56 | 79 | 20 | 1 | 20000 |
| 57 | 72 | 27 | 1 | 20000 |
| 58 | 94 | 5 | 1 | 20000 |
| 59 | 89 | 10 | 1 | 20000 |
| 60 | 84 | 15 | 1 | 20000 |
| 61 | 79 | 20 | 1 | 20000 |
| 62 | 72 | 27 | 1 | 20000 |
| 63 | 74 | 25 | 1 | 200000 |
| 64 | 74 | 25 | 1 | 100000 |
| 65 | 74 | 25 | 1 | 50000 |
| 66 | 74 | 25 | 1 | 30000 |
| 67 | 74 | 25 | 1 | 10000 |
| 68 | 74 | 25 | 1 | 200000 |
| 69 | 74 | 25 | 1 | 100000 |
| 70 | 74 | 25 | 1 | 50000 |
| 71 | 74 | 25 | 1 | 30000 |
| 72 | 74 | 25 | 1 | 10000 |
| 73 | 74.7 | 25 | 0.3 | 20000 |
| 74 | 73.5 | 25 | 1.5 | 20000 |
| 75 | 73 | 25 | 2 | 20000 |
| 76 | 72 | 25 | 3 | 20000 |
| 77 | 70 | 25 | 5 | 20000 |
| 78 | 74.7 | 25 | 0.3 | 20000 |
| 79 | 73.5 | 25 | 1.5 | 20000 |
| 80 | 73 | 25 | 2 | 20000 |
| 81 | 72 | 25 | 3 | 20000 |
| 82 | 70 | 25 | 5 | 20000 |
| 83 | 74.7 | 25 | 0.3 | 20000 |
| 84 | 73.5 | 25 | 1.5 | 20000 |
| 85 | 73 | 25 | 2 | 20000 |
| 86 | 72 | 25 | 3 | 20000 |
| 87 | 70 | 25 | 5 | 20000 |
| 88 | 74.7 | 25 | 0.3 | 20000 |
| 89 | 73.5 | 25 | 1.5 | 20000 |
| 90 | 73 | 25 | 2 | 20000 |
| 91 | 72 | 25 | 3 | 20000 |
| 92 | 70 | 25 | 5 | 20000 |
| 93 | 74 | 25 | 1 | 20000 |

It is preferable for the protective layer to contain an inorganic laminar compound, such as natural mica and synthetic mica as described in JP-A No. 2005-119273 in order to increase the oxygen blocking property.

The protective layer may contain a known additive such as a plasticizer for imparting flexibility, a surfactant for improving coatability, fine inorganic particles for controlling a surface slipping property, and/or an infrared absorbent. Further, the oil-sensitizing agent described with respect to the image recording layer may also be incorporated into the protective layer.

The adhesion property to the image recording layer and scratch resistance are considered from the viewpoints of handling of the plate. That is, when a hydrophilic protective layer containing a water-soluble polymer as a main component is layered on an oleophilic image recording layer, layer separation due to an insufficient adhesion property is liable to occur, and the separated portion causes such a defect as failure in film curing due to polymerization suppression by oxygen. Various proposals have been made for improving the adhesion property between these layers. For example, it is described in JP-B No. S54-12215 and British Patent Application Publication No. 1303578 that a sufficient adhesion property can be obtained by mixing 20% by mass to 60% by mass of an acryl-based emulsion, a water-insoluble vinyl pyrrolidone/vinyl acetate copolymer, or the like into the protective layer. Any of these known techniques can be applied to the protective layer of the photosensitive planographic printing plate precursor that is applied to the method according to the invention.

As for a coating method of such a protective layer, the protective layer may be applied by any known method such as one that is described in U.S. Pat. No. 3,458,311 and JP-A No. S55-49729. A coating amount of the protective layer is preferably in a range of from 0.01 g/m² to 10 g/m², more preferably in a range of from 0.02 g/m² to 3 g/m², and most preferably in a range of from 0.02 g/m² to 1 g/m², in terms of a coating amount after drying.

Thus, a photosensitive planographic printing plate precursor, which is applied to the development step according to the method of concentrating a waste liquid of the invention and the recycling method of the invention, is obtained.

### [Plate-Making Method]

A planographic printing plate is prepared by exposing the photosensitive planographic printing plate precursor imagewise and subjecting it to a development process. Further, in the plate-making processing according to the method of concentrating a waste liquid of the invention and the recycling method of the invention, the planographic printing plate precursor is subjected to a development process (by a developer liquid) in a development processing bath of an automatic developing machine, and then to a water washing processg and an oil-desensitizing process in this order as described above.

### [Imagewise Exposing Step]

The planographic printing plate precursor is exposed with a laser through a transparent original image including a line image, a halftone dot image, or the like, or exposed imagewise by scanning with a laser beam based on digital data.

A wavelength of a light source for use in the exposure is preferably from 300 nm to 450 nm or from 750 nm to 1400 nm. In a case in which the wavelength of the light source is from 300 nm to 450 nm, a planographic printing plate precursor having an image recording layer including a sensitizing dye, a maximum absorption wavelength of which being within the range, is used. In a case in which the wavelength of the light source is from 750 nm to 1400 nm, a planographic printing plate precursor having an image recording layer including an infrared absorbing agent, that is a sensitizing dye which exhibits absorption within the range, is used. As the light source of light having a wavelength of from 300 nm to 450 nm, a semiconductor laser is suitable. As the light source of light having a wavelength of from 750 nm to 1400 nm, a solid laser or semiconductor laser that emits infrared rays is suitable. The exposure mechanism may be any of an internal drum system, an external drum system, a flat bed system, and the like.

### [Development Processing Method]

The developer liquid can be used as a developer liquid and a development replenisher liquid for an exposed planographic printing plate precursor, and is preferably applied in a development bath of an automatic processing apparatus as described above.

In the case of developing using the automatic processing apparatus, since the developer liquid becomes exhausted in accordance with the amount of processing, the development processing ability may be restored by replenishment with a replenisher liquid or fresh developer liquid. Also, in the recycling method of the invention, the replenishment mode is preferably applied.

### [Other Plate-Making Processing]

In the pre-making processing of preparing a planographic printing plate from a planographic printing plate precursor, an entire surface may be heated before the exposure, during the exposure, or between the exposure and the development, if necessary. By the heating, the image forming reaction in the image recording layer may be accelerated and advantages such as improvement in the sensitivity and printing durability and stabilization of the sensitivity may be achieved. For the purpose of improving the image strength and printing durability, it is also effective to subject the entire surface of the developed image to post-heating or exposure. Ordinarily, the heating before the development is preferably performed under a mild condition of 150°C or lower. When the temperature for pre-heating is too high, problems such as fogging in an unexposed area may arise. The heating process after development can be performed using very strong conditions. Ordinarily, the heating is carried out in a temperature range of from 200°C to 500°C. When the temperature for the post-heating is too low, a sufficient effect of strengthening the image may not be obtained, whereas when it is excessively high, problems of deterioration of the support and thermal decomposition of the image area may occur.

### EXAMPLES

Hereinafter, the invention will be described in detail with reference to Examples, but the invention is not limited thereto. Further, with respect to the polymer compounds, the molecular weight is a weight average molecular weight (Mw) and the proportion of repeating units is indicated in mole percent, unless otherwise particularly defined.

### [Examples 1 to 9 and Comparative Examples 1 to 7]

### [I] Preparation of Planographic Printing Plate Precursor (1)

### (1) Preparation of Support

An aluminum plate (a material of JIS A 1050, that has an Al content of 99.5% by mass or more) having a thickness of 0.3 mm was subjected to a degreasing processing using a 10% by mass aqueous sodium aluminate solution at 50°C for 30 seconds in order to remove rolling oil on its surface. Then, the surface of the aluminum plate was grained using three nylon brushes having bundles of nylon bristle having a diameter of 0.3 mm embedded therewith and a water suspension (specific gravity: 1.1 g/cm³) of pumice having a median size of 25 µm, followed by thorough washing with water. This plate was subjected to etching by immersing in a 25% by mass aqueous sodium hydroxide solution at 45°C for 9 seconds, washed with water, then immersed in a 20% by mass aqueous nitric acid solution at 60°C for 20 seconds, and washed with water. At this time, an etching amount of the grained surface was about 3 g/m².

Next, using an alternating current of 60 Hz, an electrochemical roughening processing was continuously carried out on the plate. The electrolytic solution at this time was a 1% by mass aqueous nitric acid solution (containing 0.5% by mass of aluminum ions) and the temperature of the solution was 50°C. The electrochemical roughening processing was conducted using an alternating current source wave-form, which provided a rectangular alternating current having a trapezoidal waveform such that the time necessary for the current value to reach the peak from zero was 0.8 milliseconds and the duty ratio was 1:1, and using a carbon electrode as a counter electrode. Ferrite was used as an auxiliary anode. The current density was 30 A/dm² in terms of the peak value of the electric current, and 5% of the electric current flowing from the electric source was diverted to the auxiliary anode. The quantity of electricity in the nitric acid electrolysis was 175 C/dm² in terms of the quantity of electricity when the aluminum plate functioned as an anode. The plate was then washed with water by spraying.

The plate was then subjected to an electrochemical roughening processing in the same manner as in the nitric acid electrolysis using, as an electrolytic solution, a 0.5% by mass aqueous hydrochloric acid solution (containing 0.5% by mass of aluminum ions) having a temperature of the solution of 50°C and under the conditions that the quantity of electricity was 50 C/dm² in terms of the quantity of electricity when the aluminum plate functioned as an anode. Thereafter, the plate was washed with water by spraying.

Next, the plate was processed using a 15% by mass aqueous sulfuric acid solution (containing 0.5% by mass of aluminum ions) as an electrolytic solution, at a current density of 15 A/dm² to form a direct current anodized film of 2.5 g/m², washed with water, and dried to prepare a support (1).

Thereafter, in order to ensure the hydrophilicity of a non-image area, the support (1) was subjected to a silicate processing using a 2.5% by mass aqueous sodium silicate No. 3 solution at 60°C for 10 seconds, and then washed with water to obtain a support (2). An amount of Si adhered to the surface of the support (2) was 10 mg/m². A center line average roughness (Ra) of the support (2) was measured using a stylus having a diameter of 2 µm and found to be 0.51 µm.

### (2) Formation of Undercoat Layer

Next, a coating solution (1) for an undercoat layer having the following composition was coated on the support (2) so as to have a dry coating amount of 20 mg/m², thereby preparing a support having an undercoat layer for use in the experiments described below.

### <Composition of Coating Liquid (1) of Undercoat Layer>

- Compound (1) for undercoat layer having the following structure: 0.18 g
- Methanol: 55.24 g
- Water: 6.15 g

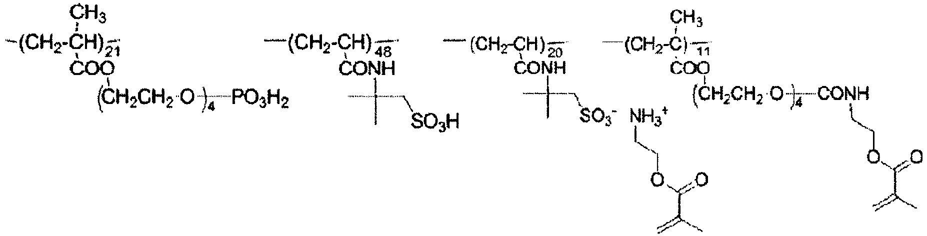

### Compound (1) for Undercoat Layer

### Mw: 100,000

### (1) Formation of Image Recording Layer

A coating solution (C) for an image recording layer was bar-coated on the undercoat layer which was formed as described above and dried in an oven at 100°C for 60 seconds to form an image recording layer having a dry coating amount of 1.0 g/m².

The coating solution (C) for an image recording layer was prepared by mixing, immediately before the coating, a photosensitive solution (1) having the following composition with a Microgel solution (1) and then stirring.

<Composition of Photosensitive solution (1)>
- Binder polymer (1) [the structure below]: 0.240 g
- Infrared absorbing agent (1) [the structure below]: 0.030 g
- Radical generator (1) [the structure below]: 0.162 g
- Polymerizable compound
   Tris(acryloyloxyethyl) isocyanurate
   (NK ESTER A-9300, manufactured by Shin-Nakamura Chemical Co., Ltd.): 0.192 g
- Hydrophilic, low-molecular compound
   (Tris(2-hydroxyethyl) isocyanurate): 0.062 g
- Hydrophilic, low-molecular compound (1) [the structure below]: 0.050 g
- Oil-sensitizing agent Phosphonium compound (1) [the structure below]: 0.055 g
- Oil-sensitizing agent
   Benzyl-dimethyl-octyl ammonium PF₆ salt: 0.018 g
- Oil-sensitizing agent Ammonium group-containing polymer [the structure below, reduced specific viscosity of 44 cSt/g/ml]: 0.035 g
- Fluorine-containing surfactant (1) [the structure below]: 0.008 g
- 2-Butanone: 1.091 g
- 1-Methoxy-2-propanol: 8.609 g

### <Composition of Microgel Solution (1)>

- Microgel (1): 2.640 g
- Distilled water: 2.425 g

The structures of the binder polymer (1), the infrared absorbing agent (2), the radical generator (1), the phosphonium compound (1), the hydrophilic, low-molecular compound (1), the ammonium group-containing polymer, and the fluorine-containing surfactant (1) are as set forth below.

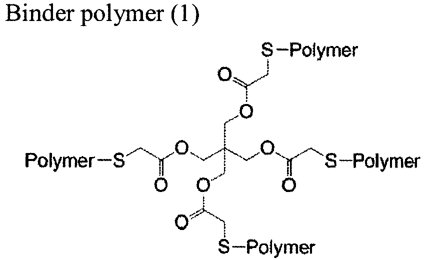

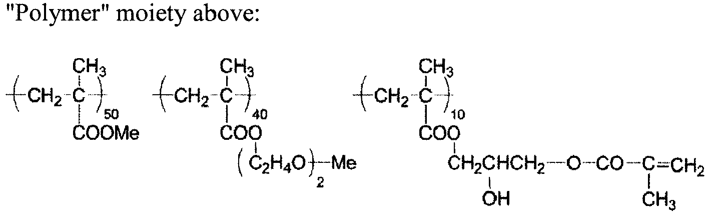

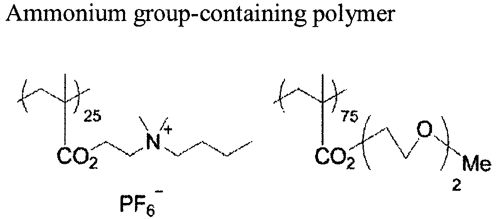

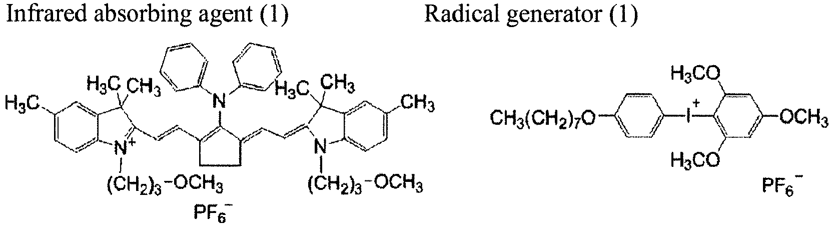

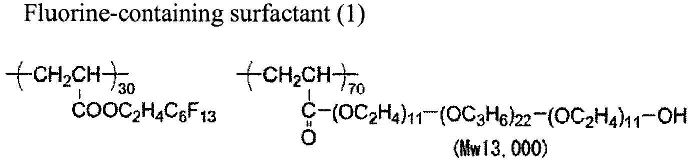

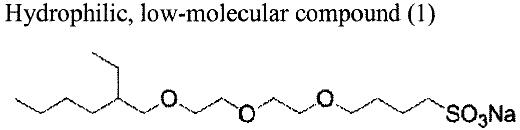

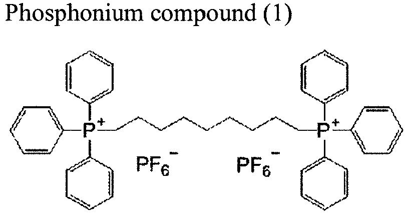

### - Synthesis of Microgel (1) -

For an oil phase component, 10 g of an adduct of trimethylolpropane and xylene diisocyanate (trade name: TAKENATE D-110N, manufactured by Mitsui Takeda Chemical Co., Ltd., 75% by mass ethyl acetate solution), 6.00 g of ARONIX SR-399 (trade name, manufactured by Toagosei Co., Ltd.), and 0.12 g of PIONIN A-41C (trade name, manufactured by Takemoto Oil & Fat Co., Ltd.) were dissolved in 16.67 g of ethyl acetate. For an aqueous phase component, 37.5 g of a 4% by mass aqueous solution of PVA-205 (trade name, manufactured by Kuraray Co., Ltd.) was formulated. The oil phase component and the aqueous phase component were mixed and emulsified using a homogenizer at 12000 rpm for 10 minutes. The obtained emulsion was added to 25 g of distilled water and stirred at room temperature for 30 minutes and further stirred at 40°C for 2 hours. The microcapsule liquid thus obtained was diluted using distilled water so as to have a solid concentration of 15% by mass, thereby affording a microgel (1). An average particle diameter of the microgel (1) was measured by a dry particle size distribution measuring apparatus (trade name: LA-910, manufactured by Horiba, Ltd.), and found to be 0.2 µm.

### (2) Formation of Protective Layer

The coating solution (1) for a protective layer having the following composition was bar-coated on the image recording layer and then dried in an oven at 120°C for 60 seconds to form a protective layer having a dry coating amount of 0.15 g/m², thereby obtaining a planographic printing plate precursor (1).

### (Preparation of Inorganic Laminar Compound Dispersion (1))

To 193.6 g of ion exchange water was added 6.4 g of synthetic mica (trade name: SOMASIF ME-100, manufactured by CO-OP Chemical Co., Ltd.) and the mixture was dispersed using a homogenizer until an average particle diameter (according to a laser scattering method) became 3 µm. An aspect ratio of the dispersed particles thus obtained was 100 or more.

### <Composition of Coating Liquid (1) for Protective Layer>

- Inorganic laminar compound dispersion (1) (obtained above): 1.5 g
- Hydrophilic polymer (1) (solids) [the structure below, Mw: 30,000]: 0.55 g
- Polyvinyl alcohol (trade name: CKS50, manufactured by Nippon Synthetic Chemical Industry Co., Ltd., sulfonic acid-modified, saponification degree: 99% by mole or more, polymerization degree: 300) 6% by mass aqueous solution: 0.10 g
- Polyvinyl alcohol (trade name: PVA-405, manufactured by Kuraray Co., Ltd., saponification degree: 81.5% by mole, polymerization degree: 500) 6% by mass aqueous solution: 0.03 g
- Surfactant (trade name: EMALEX 710, manufactured by Nihon Emulsion Co., Ltd.) 1% by mass aqueous solution: 0.86 g
- Ion exchange water: 6.0 g

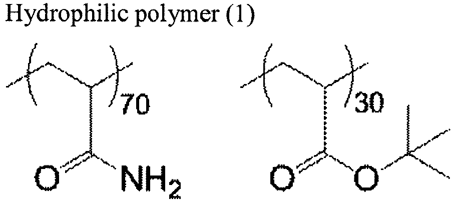

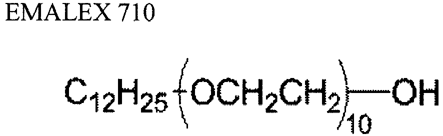

Thus, a photosensitive planographic printing plate precursor for evaluation, having the image recording layer and the protective layer on the support, was prepared. The obtained photosensitive planographic printing plate precursor was subjected to plate-making by the following steps, and the waste liquid produced in the development step was concentrated.

### [Preparation of Developer liquid]

A developer liquid (A) through a developer liquid (M) having the following compositions were prepared.

### <Developer liquid (A)>

- Nonionic surfactant (polyoxyethylene naphthalene ether) (trade name: NEWCOL B13, manufactured by Nippon Nyukazai Co., Ltd., solid content: 100%): 5.0% by mass
- Chelating agent ((trisodium ethylenediaminedisuccinate) trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.1% by mass
- Preservative (trade name: Acticide LA1206, manufactured by Xenso Japan Co., Ltd.): 0.1% by mass

Water was added to these components so that a total amount is 100% by mass (pH: 9.4).

NEWCOL B13 (trade name, manufactured by Nippon Nyukazai Co., Ltd.), that was a surfactant used for formation of the developer liquids (A) to (C), and (I) to (K), is a nonionic surfactant which has a naphthalene skeleton and is included in Formula (B).

### <Developer liquid (B)>

- Nonionic surfactant (polyoxyethylene naphthalene ether) (trade name: NEWCOL B13, manufactured by Nippon Nyukazai Co., Ltd., solid content: 100%): 5.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.1% by mass
- Preservative (trade name: ACTICIDE LA1206, manufactured by Xenso Japan Co., Ltd.): 0.1 % by mass

Water was added to these components so that a total amount is 100% by mass.

### (Phosphoric acid was added thereto to adjust the pH to 6.0.)

### <Developer liquid (C)>

- Nonionic surfactant (polyoxyethylene naphthalene ether) (trade name: NEWCOL B13, manufactured by Nippon Nyukazai Co., Ltd., solid content: 100%): 5.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.1% by mass
- Preservative (trade name: ACTICIDE LA1206, manufactured by Xenso Japan Co., Ltd.): 0.1 % by mass

Water was added to these components so that a total amount is 100% by mass.

### (Phosphoric acid was added thereto to adjust the pH to 8.0.)

### <Developer liquid (D)>

- Anionic surfactant (sodium alkyl naphthalene sulfonate) (trade name: PELEX NBL, manufactured by Kao Corporation, 35% aqueous solution): 10.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.):· 0.1% by mass
- Preservative (trade name: ACTICIDE LA1206, manufactured by Xenso Japan Co., Ltd.): 0.1% by mass

Water was added to these components so that a total amount is 100% by mass. (pH: 8.0)

PELEX NBL (trade name, manufactured by Kao Corporation), that was a surfactant used for formation of the developer liquid (D), is an anionic surfactant which has a naphthalene skeleton and is included in Formula (A).

### <Developer liquid (E)>

- Anionic surfactant (polyoxyethylene aryl ether sulfate ester) (trade name: NEWCOL B4-SN, manufactured by Nippon Nyukazai Co., Ltd., 60% aqueous solution): 7.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.05% by mass
- Preservative (trade name: BIO HOPE, manufactured by K. I. Chemical Industry Co., Ltd.): 0.1% by mass

Water was added to these components so that a total amount is 100% by mass. (pH: 8.5)

NEWCOL B4-SN (trade name, manufactured by Nippon Nyukazai Co., Ltd.), that was a surfactant used for formation of the developer liquid (E), is an anionic surfactant which has a naphthalene skeleton and is included in Formula (A).

### <Comparative Developer liquid (F)>

- Anionic surfactant (sodium dodecyldiphenyletherdisulfonate) (trade name: ELEMINOL MON-2, manufactured by Sanyo Chemical Industries, Ltd., 47% aqueous solution): 10.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.05% by mass
- Preservative (trade name: BIO HOPE, manufactured by K. I. Chemical Industry Co., Ltd.): 0.1% by mass

Water was added to these components so that a total amount is 100% by mass. (pH: 9.0)

ELEMINOL MON-2 (trade name, manufactured by Sanyo Chemical Industries, Ltd.), that was a surfactant used for formation of the developer liquid (F), is an anionic surfactant which has no naphthalene skeleton in the molecule and is outside the scope of the invention.

### <Comparative Developer liquid (G)>

- Nonionic surfactant (polyoxyethylene distyrenated phenyl ether) (trade name: EMULGEN A-90, manufactured by Kao Corporation, solid content: 100%): 7.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.05% by mass
- Preservative (trade name: BIO HOPE, manufactured by K. I. Chemical Industry Co., Ltd.): 0.1% by mass

Water was added to these components so that a total amount is 100% by mass. (pH: 8.8)

EMULGEN A-90 (trade name, manufactured by Kao Corporation), that was a surfactant used for formation of the developer liquid (G), is a nonionic surfactant which has no naphthalene skeleton in the molecule and is outside the scope of the invention.

### <Comparative Developer liquid (H)>

- Anionic surfactant (dodecylbenzene sulfonate) (trade name: NEWCOL210, manufactured by Nippon Nyukazai Co., Ltd., 50% aqueous solution): 7.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.) 0.05% by mass
- Preservative (trade name: BIO HOPE, manufactured by K. I. Chemical Industry Co., Ltd.): 0.1% by mass

Water was added to these components so that a total amount is 100% by mass. (pH: 8.9)

NEWCOL 210 (trade name, manufactured by Nippon Nyukazai Co., Ltd.), that was a surfactant used for formation of the developer liquid (H), is an anionic surfactant which has no naphthalene skeleton in the molecule and is outside the scope of the invention.

### <Developer liquid (I)>

- Nonionic surfactant (polyoxyethylene naphthalene ether) (trade name: NEWCOL B13, manufactured by Nippon Nyukazai Co., Ltd., solid content: 100%): 5.0% by mass
- Benzyl alcohol: 1.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.1 % by mass
- Preservative (trade name: ACTICIDE LA1206, manufactured by Xenso Japan Co., Ltd.): 0.1 % by mass

Water was added to these components so that a total amount is 100% by mass.

### (Phosphoric acid was added thereto to adjust the pH to 8.0.)

### <Developer liquid (J)>

- Nonionic surfactant (polyoxyethylene naphthalene ether) (trade name: NEWCOL B13, manufactured by Nippon Nyukazai Co., Ltd., solid content: 100%): 5.0% by mass
- Benzyl alcohol: 2.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.1% by mass
- Preservative (trade name: ACTICIDE LA1206, manufactured by Xenso Japan Co., Ltd.): 0.1 % by mass

Water was added to these components so that a total amount is 100% by mass.

### (Phosphoric acid was added thereto to adjust the pH to 8.0.)

### <Comparative Developer liquid (K)>

- Nonionic surfactant (polyoxyethylene naphthalene ether) (trade name: NEWCOL B13, manufactured by Nippon Nyukazai Co., Ltd., solid content: 100%): 5.0% by mass
- Benzyl alcohol (boiling temperature: 205°C): 4.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.1% by mass
- Preservative (trade name: ACTICIDE LA1206, manufactured by Xenso Japan Co., Ltd.): 0.1% by mass

Water was added to these components so that a total amount is 100% by mass.

### (Phosphoric acid was added thereto to adjust the pH to 8.0.)

The comparative developer liquid (K) was a developer liquid having a content of the specific organic solvent of 2.0% by mass or more and was outside the scope of the invention.

### <Comparative Developer liquid (L)>

- Nonionic surfactant (polyoxyethylene naphthalene ether) (trade name: NEWCOL B13, manufactured by Nippon Nyukazai Co., Ltd., solid content: 100%): 5.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.1% by mass
- Preservative (trade name: ACTICIDE LA1206, manufactured by Xenso Japan Co., Ltd.): 0.1% by mass

Water was added to these components so that a total amount is 100% by mass.

### (Phosphoric acid was added thereto to adjust to pH to 5.0.)

The comparative developer liquid (L) was a developer liquid which has a pH of 5.0 and was outside the scope the invention.

### <Comparative Developer liquid (M)>

- Nonionic surfactant (polyoxyethylene naphthalene ether) (trade name: NEWCOL B13, manufactured by Nippon Nyukazai Co., Ltd., solid content: 100%): 5.0% by mass
- Chelating agent (trisodium ethylenediaminedisuccinate) (trade name: CHELEST EDDS-35, manufactured by Chelest Corporation): 0.5% by mass
- Silicone-containing defoamer (trade name: TSA739, manufactured by Momentive Performance Materials Japan LLC, Ltd.): 0.1% by mass
- Preservative (trade name: ACTICIDE LA1206, manufactured by Xenso Japan Co., Ltd.): 0.1% by mass

Water was added to these components so that a total amount is 100% by mass.

### (Sodium hydroxide was added thereto to adjust the pH to 10.0.)

The comparative developer liquid (M) was a developer liquid having a pH of 10.0 and was outside the scope of the invention.

### <Plate-Making of Photosensitive Planographic Printing Plate Precursor>

For the obtained photosensitive planographic printing plate precursor (1), the following steps were carried out to make a plate, thereby obtaining a planographic printing plate.

### (Exposing Step)

Exposure of the obtained photosensitive planographic printing plate precursor was carried out under any one condition of the following exposure A or exposure B.

### <Exposure A>

The obtained planographic printing plate precursor was exposed using a Luxel PLATESETTER T-6000 III (trade name, manufactured by Fujifilm Corporation) equipped with an infrared semiconductor laser under the conditions of a rotation speed of an external drum of 1000 rpm, a laser output of 70%, and a resolution of 2400 dpi (dots per inch). The exposed image included a solid image and a 50% halftone dot chart of a 20 µm dot FM screen.

### <Exposure B>

The obtained planographic printing plate precursor was exposed using a TRENDSETTER 3244VX (trade name, manufactured by Creo Co., Ltd.) equipped with an infrared semiconductor laser under conditions of a power output of 6.4 W, a rotation speed of an external drum of 150 rpm, and a resolution of 2400 dpi. The exposed image included a solid image and a 50% halftone dot chart of a 20 µm dot FM screen.

### (Development step (i), Water Washing Step (ii), and Oil-Desensitizing Processing Step (iii))

The obtained planographic printing plate precursor after exposure was subjected to plate-making using the automatic developing machine 1 shown in Fig. 2. Specifically, a development step in which an unexposed area in the image recording layer was removed from the plate precursor using a developer liquid described in Table 3 shown below in a development processing unit 14, a water washing step in which the developed planographic printing plate was subjected to water washing in a water washing unit 16, and an oil-desensitizing step in which the following oil-desensitizing processing liquid was applied to the water-washed planographic printing plate in an oil-desensitizing processing unit 18, were sequentially carried out to obtain a planographic printing plate thus made.

Conditions in the development step are shown below.
Developer liquid temperature: all 25°C
Transportation speed: 100 cm/min.
Brush rotation speed in the development unit: 100 rpm
Conditions for supplying water in the water washing unit: Water (25°C (room temperature), supply amount: 10 L/min)
Oil-desensitizing processing liquid: gum liquid (trade name: FN-6, manufactured by Fujifilm Corporation)/tap water = 1/1 (pH: 3.5)
Oil-desensitizing processing liquid temperature: 25°C (room temperature), time for passing through the oil-desensitizing processing liquid tank: 10 L/min)

### [Evaporation-concentration Step]

100 L of the developer liquid was put into an automatic developing machine (20 L and 80 L were put into the developing tank and the external tank, respectively), and then while not carrying out exchange or replenishment of the developer liquid, 1500 m² of the planographic printing plate precursor was subsequently subjected to a plate-making process, and then the development processing liquid was discharged as a waste liquid from the automatic developing machine. The obtained waste liquid was concentrated by a waste liquid concentration apparatus XR-2000 (trade name, manufactured by Fujifilm Global Graphic Systems Co., Ltd.) to have a concentration ratio shown in Table 2 below.

### (Evaluation of Plate-Making Process)

### <Developing Speed>

After exposure (exposure A), the obtained planographic printing plate was stored under a storage environment of 30°C and 75%RH for 10 days, and then subjected to a development process with no imagewise exposure. Herein, the developer liquid described in Table 3 was used as a developer liquid.

A non-image area density on the planographic printing plate obtained by development was measured using a reflection densitometer RD-918 from Macbeth, and the cyan density was measured using a red filter provided in the densitometer. The difference between the density value of the support which was at the state that a hydrophilic surface processing of which was completed but before the protective layer, the photosensitive layer, and the undercoat layer were coated thereon and the density value of the non-image area after being subjected to the development process was evaluated according to the following criteria.

A smaller difference found by the comparison was evaluated as superior developability of the non-image area and a better developing speed. "A" was a level at which practically non-problematic, and "C" was a level at which practically problematic.
A: The difference between the density value of the non-image area and the density value of the support was +0.02 or less.
B: The difference between the density value of the non-image area and the density value of the support was more than +0.02 but +0.03 or less.
C: The difference between the density value of the non-image area and the density value of the support was more than +0.03.

### <Generation of Development Scum>

After exposure (exposure A), ten sheets of planographic printing plates (each having a size of 3.0 m²) that had been subjected to the development process were visually observed for dirt on the plates (the number of scum adhereed to the plate) and the degree of re-adherence of the image recording layer components which were once removed during the development was evaluated according to the following index.
A: There was no re-adherence of components to be removed, which was thus extremely good.
B: Very little of removed components was observed, but this could be easily removed by a waste cloth or the like, which was at a level acceptable in practical use.
C: There was much of removed components, which could not be easily removed even by wiping with a waste cloth, which was thus problematic in practical use.
D: There was much re-adherence of removed components, which was thus unfavorable.

### (Evaluation of Concentrated Liquid in Evaporation-concentration Step)

When the waste liquid was concentrated in the evaporation-concentration step, the foaming property of the waste liquid in the concentration apparatus was investigated. The liquid obtained by condensing water vapor separated from the waste liquid that foamed in the apparatus was not suitable as regenerated water and thus not provided for the subsequent use.

### [II] Evaluation of Planographic Printing Plate Precursor and Planographic Printing Plate Obtained

The on-press developability of the planographic printing plate precursor (1) was checked in the following manner.

Furthermore, the inking properties (initial inking property, and inking property with a spot color ink) and printing durability of the planographic printing plate obtained through the plate-making processing were evaluated in the following manner. The inking property in a spot color ink was further evaluated in a case in which the planographic printing plate precursor was aged over time.

### (1) On-Press Developability

The planographic printing plate precursor thus-obtained was exposed using a Luxel PLATESETTER T-6000 III equipped with an infrared semiconductor laser, manufactured by Fujifilm Corporation, under the conditions of a rotational number of an outer surface drum of 1000 rpm, a laser power output of 70%, and resolution of 2400 dpi. The exposed image contained a solid image and a 50% halftone dot chart of a 20 µm dot FM screen.

The obtained printing plate precursor after exposure was mounted on a plate cylinder of a LITHRONE 26 printer manufactured by Komori Corporation without subjecting it to a development process. Using a dampening solution with ECOLITY-2 (manufactured by Fujifilm Corporation)/tap water = 2/98 (volume ratio) and Values-G (N) Black Ink (manufactured by DIC Corporation), the dampening solution and ink were supplied according to the standard automatic printing start method of the LITHRONE 26 to conduct on-press development of the plate precursor. Then, printing was carried out on100 sheets of Tokubishi art paper (76.5 kg) at a printing speed of 10000 sheets per hour.

At this time, the number of sheets of printing paper required until it reached a state where the ink was no longer transferred to the unexposed area (non-image area) of the image recording layer was measured as an index for the on-press developability. In any case of using any planographic printing plate precursor, the number of sheets of paper was 100 or less and the on-press developability was found to be good.

### (2) Inking Property

After exposure (exposure A), the planographic printing plate obtained by carrying out the development process was printed using a printer (trade name: DIA 1F-2, manufactured by Mitsubishi Heavy Industries, Ltd.). A number of sheets printed from starting of the printing to obtainment of a good print having ink density with no blurring in the in its image area was evaluated. As a printing ink, GRAPH G (N) (trade name) manufactured by DIC Corporation was used. As the dampening solution, IF MARK II (trade name, manufactured by Fujifilm Corporation) was used. After starting the printing, the ink was gradually adhered to the image recording layer and as a result, the ink density on the paper increased.

The number of printed sheets at a time when the ink density reached a standard print density (Macbeth reflection density D = 1.80) was evaluated as the inking property according to the following criteria. A smaller number of printed sheets until the inking indicated a superior inking property.
A: The number of sheets until the inking was 12 or less.
B: The number of sheets until the inking was from 13 to 14.
C: The number of sheets until the inking was from 15 to 24.
D: The number of sheets until the inking was 25 or more.

### (3) Dirt Resistance

After exposure (exposure B), the planographic printing plate obtained by carrying out the development process was mounted on a cylinder of a printer (trade name: SPEEDMASTER 52, manufactured by Heidelberg Co.). Dampening water [a mixture of IF102 (trade name, manufactured by Fujifilm Corporation: etching solution)/water = 3/97 (volume ratio)] and Black Ink (trade name: TRANS-G (N), manufactured by DIC Corporation) were supplied and then printing of 100 sheets was carried out at a printing speed of 6000 sheets per hour.

Thereafter, the water scale of the printer was made smaller so that the supply amount of water was gradually reduced until entanglement of the halftone image occurred. The degree of occurrence of entangling dirt at this time was evaluated according to the following index. The results are shown in Table 3.
A: Entanglement hardly occurred, the water/ink balance was sufficient, and the dirt resistance was good.
B: Some entanglement occurred, but the level of dirt resistance was acceptable in practical use.
C: There was a state where entanglement occurred and the shadow side of the halftone dot collapsed, which was problematic in practical use.
D: Serious entanglement occurred only with a slightly reduced water absorption amount.

**[Table 3]**

| | Planographic printing plate precursor | Developer liquid | | Evaluation of Planographic Printing Plate in Plate-Making Step | | | | Waste liquid concentration step | |
|---|---|---|---|---|---|---|---|---|---|
| | | Type | pH | Developing speed | Generation of development scum | Inking property | Dirt resistance | Concentration ratio | Evaluation of Regenerated water in Waste liquid concentration step |
| Example 1 | (1) | Developer liquid (A) | 9.4 | A | B | A | A | 1/4 | No problem |
| Example 2 | (1) | Developer liquid (B) | 6.0 | A | A | A | A | 1/4 | No problem |
| Example 3 | (1) | Developer liquid (C) | 8.0 | A | B | A | A | 1/4 | No problem |
| Example 4 | (1) | Developer liquid (B) | 8.0 | A | A | A | A | 1/2 | No problem |
| Example 5 | (1) | Developer liquid (B) | 8.0 | A | A | A | A | 1/10 | No problem |
| Example 6 | (1) | Developer liquid (D) | 8.0 | A | B | B | A | 1/4 | No problem |
| Example 7 | (1) | Developer liquid (E) | 8.5 | A | B | B | A | 1/4 | No problem |
| Example 8 | (1) | Developer liquid (I) | 8.0 | A | A | A | A | 1/4 | No problem |
| Example 9 | (1) | Developer liquid (J) | 8.0 | A | A | A | A | 1/4 | No problem |
| Comparative Example 1 | (1) | Comparative developer liquid (F) | 9.0 | B | B | C | B | 1/4 | Foamed |
| Comparative Example 2 | (1) | Comparative developer liquid (G) | 8.8 | C | D | B | A | 1/4 | Viscosity Increased |
| Comparative Example 3 | (1) | Comparative developer liquid (H) | 8.9 | B | C | C | B | 1/4 | Foamed |
| Comparative Example 4 | (1) | Comparative developer liquid (K) | 8.0 | A | A | A | A | 1/4 | Plate Overdeveloped |
| Comparative Example 5 | (1) | Developer liquid (B) | 8.0 | A | B | A | A | 1/12 | Viscosity Increased |
| Comparative Example 6 | (1) | Comparative developer liquid (L) | 5.0 | A | C | A | A | 1/4 | No problem |
| Comparative Example 7 | (1) | Comparative developer liquid (M) | 10.0 | A | C | A | A | 1/4 | No problem |

From the results shown in Table 3, it can be understood that in the method of concentrating a waste liquid of Examples 1 to 9, using the developer liquid according to the invention, the developing speed during the development process was good, generation of development scum was suppressed, and thus, the performance of the planographic printing plate obtained by the plate-making processing was good.

On the other hand, in Comparative Examples 1 to 4, in which the comparative developer liquids, which employed surfactants which are outside the scope of the invention, were used, it was difficult to concentrate the liquid due to occurrence of foaming or viscosity increasing during the concentrating of the waste liquid, and as a result, it was difficult to obtain regenerated water. Further, in Comparative Example 4, a phenomenon that a halftone dot image became thin (over-development) occurred due to excessive progress of the development reaction caused by an excess content of the specific organic solvent in the developer liquid. Further, in Comparative Example 5 in which the liquid was concentrated to more than 1/10, an increase in the viscosity of the waste liquid was remarkable. In Comparative Examples 6 and 7, in which the pH of the developer liquid was outside the scope of the invention, there was no problem in concentrating of the waste liquid, but generation of development scum during the development was remarkable, and failure of getting dirt on the opposite side of the plate occurred, which was at an unacceptable level in practical use.

### [Regenerated Water Supplying Step]

The regenerated water obtained from the waste liquids of Examples 1 to 9, which had been among those obtained through the evaporation-concentration step and the subsequent regenerated water generating step and evaluated as causing no problem in the concentration step, were respectively supplied to a replenishment water tank, and a required amount thereof was circulated to a development bath of an automatic developing machine via the replenishment water tank.

Thereafter, using the developer liquids of Examples 1 to 9, the regenerated water obtained from these developer liquids was supplied as replenishment water, while a subsequent plate-making processing was carried out. For all of these, good plate-making was carried out in the subsequent plate-making processing with 1500 m² of the planographic printing plate precursor. Here, no problem was caused in any cases.

The disclosure of Japanese Patent Application 2012-147791 is herein incorporated by reference. Further, all publications, patents, patent applications, and technical standards mentioned in this specification are herein incorporated by reference to the same extent as if each individual publication, patent, patent application, or technical standard was specifically and individually indicated to be incorporated by reference.

## Claims

1. A method of concentrating a waste liquid produced by developing a photosensitive planographic printing plate, the method comprising:
obtaining a waste liquid that is produced by:
exposing a photosensitive planographic printing plate precursor, comprising: (i) a radical-polymerizable image recording layer comprising: (a) an infrared absorbing dye, (b) a polymerization initiator, and (c) a polymerizable compound, and (ii) a protective layer, in this order on a support, and
subjecting, in a development processing bath of an automatic developing machine for development, the exposed photosensitive planographic printing plate precursor to a development process by using a developer liquid that contains at least one surfactant selected from the group consisting of an anionic surfactant having a naphthalene skeleton and a nonionic surfactant having a naphthalene skeleton in an amount of 1% by mass to 10% by mass, that contains an organic solvent that has a boiling temperature in a range of from 100°C to 300°C in an amount of equal to or less than 2% by mass, and that has a pH of 6.0 to 9.5; and
evaporation-concentrating, in an evaporation-concentration apparatus, the waste liquid such that a ratio of an amount of the waste liquid after the concentration to an amount of the waste liquid before the concentration is from 1/10 to 1/2 on a volume basis.

2. The method according to claim 1, further comprising producing regenerated water by condensing, via cooling, water vapor generated during the evaporation-concentrating.

3. The method according to claim 1 or claim 2, wherein the surfactant is a compound comprising a polyoxyalkylene chain that comprises at least one selected from the group consisting of an oxyethylene group and an oxypropylene group.

4. The method according to claim 3, wherein a total number of the oxyethylene group and the oxypropylene group contained in the polyoxyalkylene chain, as a repeating unit, is from 5 to 30.

5. The method according to any one of claims 1 to 4, wherein the protective layer comprises a hydrophilic polymer comprising a repeating unit represented by the following Formula (1) and a repeating unit represented by the following Formula (2): 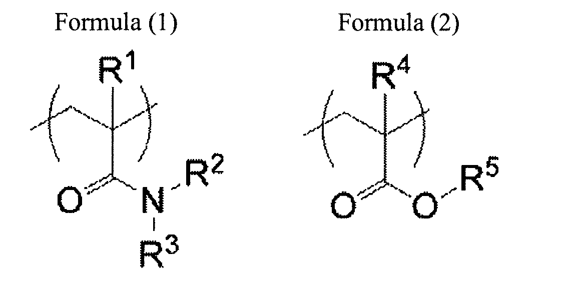 wherein, in Formulae (1) and (2), each of R¹ and R⁴ independently represents a hydrogen atom or a methyl group; each of R² and R³ independently represents a hydrogen atom, a methyl group, or an ethyl group; R⁵ represents a linear, branched, or cyclic unsubstituted alkyl group having 2 to 8 carbon atoms, a substituted alkyl group that may have an aromatic ring or a heterocycle as a substituent, or a substituent represented by the following Formula (3); 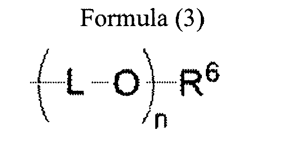 wherein, in Formula (3), L represents an alkylene group having 2 to 6 carbon atoms; R⁶ represents a linear, branched, or cyclic unsubstituted alkyl group having 4 to 8 carbon atoms or an aromatic substituted alkyl group; and n represents an average addition molar number of the polyether and is in a range of from 2 to 4.

6. The method according to claim 5, wherein the hydrophilic polymer further comprises a repeating unit represented by the following Formula (4): 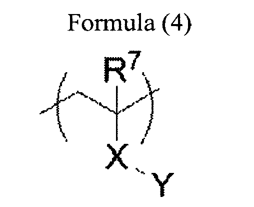 wherein, in Formula (4), R⁷ represents a hydrogen atom or a methyl group; X represents a single bond, a divalent linking group selected from structures represented by the following Structural Group (5), or a divalent linking group formed by a combination of a plurality of structures selected from structures represented by the following Structural Group (6); and Y represents a carboxylic acid group, a carboxylate salt group, a sulfonic acid group, a sulfonate salt group, a phosphoric acid group, a phosphate salt group, a phosphonic acid group, a phosphonate salt group, a hydroxyl group, a carboxybetaine group, a sulfobetaine group, an ammonium group, or a polyether group represented by the following Formula (7): 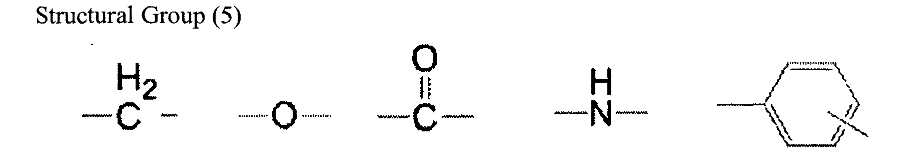 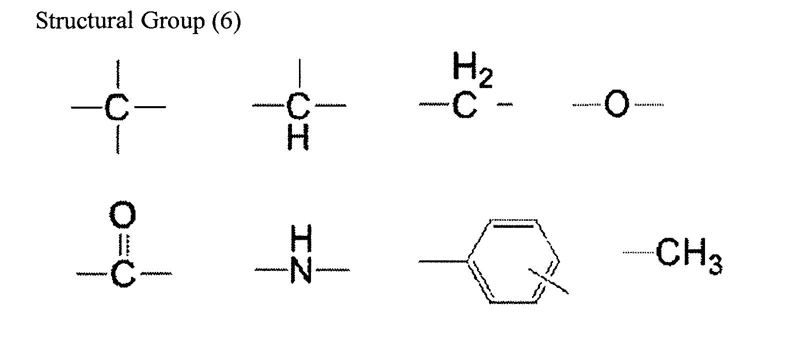 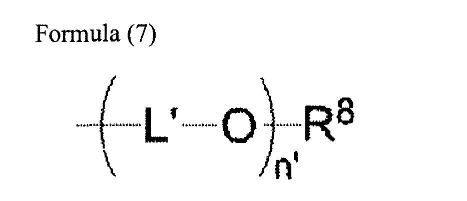 wherein, in Formula (7), L' represents an alkylene group having 2 or 3 carbon atoms; R⁸ represents a hydrogen atom or a methyl group; and n' represents an average addition molar number of the polyether and is in a range of from 2 to 4.

7. A method of recycling a waste liquid produced by development of a photosensitive planographic printing plate, the method comprising:
exposing a photosensitive planographic printing plate precursor, comprising: (i) a radical-polymerizable image recording layer comprising: (a) an infrared absorbing dye, (b) a polymerization initiator, and (c) a polymerizable compound, and (ii) a protective layer, in this order on a support; and
subjecting, in a development processing bath of an automatic developing machine for development, the exposed photosensitive planographic printing plate precursor to a development process by using a developer liquid that contains at least one surfactant selected from the group consisting of an anionic surfactant having a naphthalene skeleton and a nonionic surfactant having a naphthalene skeleton in an amount of 1 % by mass to 10% by mass, that contains an organic solvent that has a boiling temperature in a range of from 100°C to 300°C in an amount of equal to or less than 2% by mass, and that has a pH of 7.0 to 9.5;
evaporation-concentrating, in an evaporation-concentration apparatus, a waste liquid that is produced by the development process, such that a ratio of an amount of the waste liquid after the concentration to an amount of the waste liquid before the concentration is from 1/10 to 1/2 on a volume basis;
producing regenerated water by condensing, via cooling, water vapor generated in the evaporation-concentrating; and
supplying the regenerated water to the automatic developing machine.

8. The method according to claim 7, further comprising, after the development process, subjecting the photosensitive planographic printing plate precursor to plate-making by washing with water and oil-desensitizing of a non-image area with an oil-desensitizing liquid.
